(19) Europäisches Patentamt
European Patent Office
Office européen des brevets

(11) **EP 2 242 348 A1**

(12) **EUROPEAN PATENT APPLICATION**
published in accordance with Art. 153(4) EPC

(43) Date of publication:
**20.10.2010 Bulletin 2010/42**

(51) Int Cl.:
***H05K 13/04*** *(2006.01)* ***B25J 15/06*** *(2006.01)*

(21) Application number: **09701919.4**

(22) Date of filing: **19.01.2009**

(86) International application number:
**PCT/JP2009/050667**

(87) International publication number:
**WO 2009/091061 (23.07.2009 Gazette 2009/30)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **18.01.2008 JP 2008008765**
**28.08.2008 JP 2008219247**

(71) Applicant: **Kyocera Corporation**
**Kyoto-shi**
**Kyoto 612-8501 (JP)**

(72) Inventor: **HAMASHIMA, Hiroshi**
**Satsumasendai-shi**
**Kagoshima 895-0292 (JP)**

(74) Representative: **HOFFMANN EITLE**
**Patent- und Rechtsanwälte**
**Arabellastrasse 4**
**81925 München (DE)**

(54) **VACUUM HOLDING NOZZLE**

(57) An object of the present invention is to provide a vacuum suction nozzle that is capable of attaining a speed-up of mounting operation and carrying out a high density of mounting. In order to solve the above, in a vacuum suction nozzle 1 comprising a suction surface 2 whereon an object is suctioned by vacuum, and a suction orifice 3 communicating with the suction surface 2, it is characterized in that a tip end portion including the suction surface 2 is formed from ceramics, the ceramics includes a main component and a second component, the second component having a mean crystal grain size larger than the mean crystal grain size of the main component, and the crystal grains of the second component protrude more than the crystal grains of the main component on the suction surface 2.

Fig. 3

**Description**

Technical Field

The present invention relates to a vacuum suction nozzle suitably used in an electronic component mounter for mounting chip electronic components such as chip capacitor or chip resistor on a circuit board.

Background Art

Chip electronic components such as chip capacitor or chip resistor have conventionally been mounted by picking up the component by vacuum suction onto a suction surface provided at the tip end of a vacuum suction nozzle installed on an electronic component mounter, carrying the component in this state and placing it at a predetermined position of a circuit board. Position of the chip electronic component is determined by directing light to the chip electronic component, capturing the reflected light therefrom with a CCD camera and analyzing the shape of the chip electronic component or the positions of electrodes with an image analyzing apparatus.

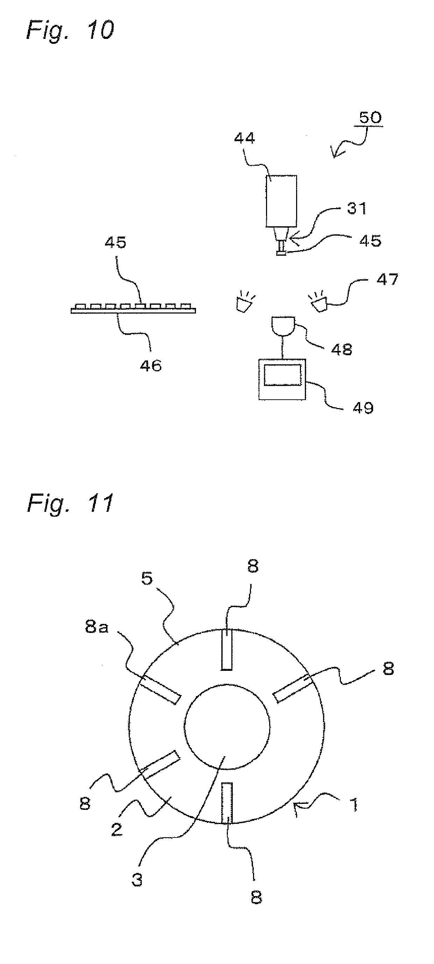

Fig. 10 schematically shows the constitution of an electronic component mounting apparatus that uses an electronic component mounter equipped with a vacuum suction nozzle for mounting chip electronic components on a circuit board.

The electronic component mounting apparatus 50 shown in Fig. 10 includes a vacuum suction nozzle 31 installed on an electronic component mounter 44, a tray 46 having electronic components 45 placed thereon, a light 47 for directing light to the electronic components 45 suctioned by the vacuum suction nozzle 31, a CCD camera 48 that receives reflected light from the electronic components 45, and an image analyzing apparatus 49 that applies image analysis to the reflected light received by the CCD camera 48.

In the electronic component mounting apparatus 50, when the vacuum suction nozzle 31 moves to the tray 46 and picks up the electronic component 45 placed on the tray 46, the light 47 directs light to the electronic component 45 suctioned by the vacuum suction nozzle 31, and the CCD camera 48 receives the light reflected on the body and electrodes of the electronic component 45. Image captured by the CCD camera 48 is analyzed by the image analyzing apparatus 49 to determine the position of the electronic component 45. Based on this data, the vacuum suction nozzle 31 carrying the electronic component 45 suctioned thereon is moved to a predetermined position of a circuit board (not shown) thereby to mount the electronic component 45 on the circuit board.

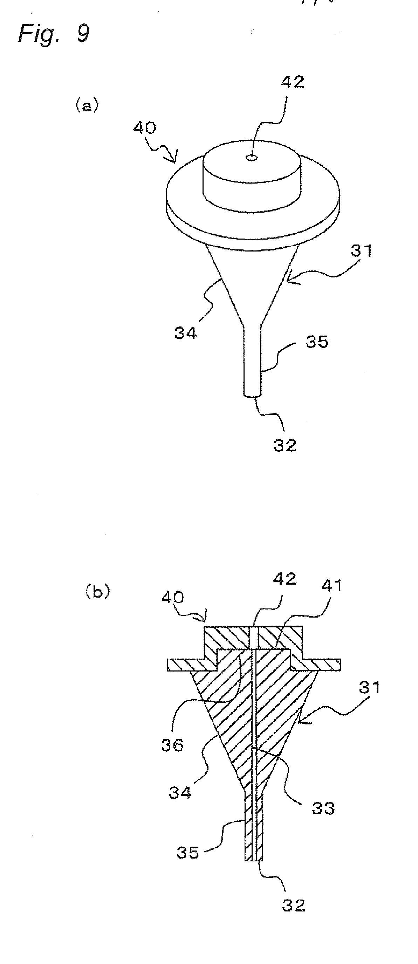

Fig. 9 shows an example of the constitution of the vacuum suction nozzle as incorporated into a holding member of the electronic component mounter, Fig. 9(a) is a perspective view thereof and Fig. 9(b) is a longitudinal sectional view thereof.

The vacuum suction nozzle 31 has a cylindrical portion 35 having a suction surface 32 formed on the tip end face for holding an electronic component by vacuum suction, a conical portion 34 that tapers off toward the cylindrical portion 35 and is provided on the side of the cylindrical portion 35 opposite to the suction surface 32, and a head 36 provided on the end face of the base where the conical portion 34 opposes the suction surface 32. A hole that penetrates the cylindrical portion 35 through the center thereof extends into the conical portion 34 and the head 36 to form a suction orifice 33.

The holding member 40 has a socket 41 formed at the center thereof, into which the head 36 of the vacuum suction nozzle 31 fits, with a suction orifice 42 formed at the center thereof to communicate with the suction orifice 33, so that the head 36 of the vacuum suction nozzle 31 is fitted into the socket 41 and mounted on the electronic component mounter.

The vacuum suction nozzle 31 is formed from a material such as ceramics or cemented carbide having high wear resistance.

Patent Document 1, for example, describes that position of a chip component can be detected by using ceramics having high wear resistance in the tip end portion of the suction nozzle that suctions the chip component and rendering the tip end portion of the suction nozzle with a color that has a lower image input level than that of the chip component when the tip end portion of the suction nozzle is captured by a camera. It is also described that the suction nozzle has high wear resistance and image processing can be carried out reliably when the chip component is picked up by the nozzle.

However, when a material having high wear resistance such as ceramics is used, since the material has a low coefficient of friction, slippage occurs in the contact surface between the chip component and the suction nozzle when the mounter is operated at a higher speed, and stable accuracy cannot be achieved in mounting the electronic component on the circuit board. For example, in order to solve this problem, Patent Document 2 discloses a suction nozzle that suppresses slippage of the electronic component and is capable of achieving durability and stable accuracy of mounting at the same time, by forming the nozzle body from a base material having high wear resistance and high impact resistance to ensure durability, and providing a contact material, having higher coefficient of friction than that of the base material, on the suction surface of the suction nozzle.

It is a common practice to make the suction surface of the suction nozzle smooth by polishing the end face of the nozzle with abrasive. When the surface is polished by using abrasive, a number of straight streaks are formed to run in one direction on the suction surface. As a result, air leaks through the streaks when an electronic component is held by vacuum suction, thus decreasing the suction force. To solve this problem, Patent Document 3 discloses a suction nozzle in which a suction surface having surface roughness of 0.5 to 5 $\mu$m at the maximum (Ry) is formed by applying shot blast to the suction surface or depositing hard particles measuring 0.5 to 2 $\mu$m in diameter on the tip end face to form the suction surface. Accordingly, a suction nozzle having such a constitution can reliably hold the electronic component without allowing positional deviation of the electronic component to occur or the electronic component to drop off when moving at a high speed.

Patent Document 4 discloses such a suction nozzle that has a fluid passage formed therethrough to penetrate from a suction orifice to the circumference of the suction surface in the suction surface of the suction nozzle, so that negative pressure is generated in the fluid passage by the Bernoulli's effect by flowing a gas at a high velocity through the fluid passage, thereby to hold a work with a suction force that is increased by the negative pressure over the conventional suction nozzle of the same diameter. Suction force of this suction nozzle does not decrease even when the suction surface of the vacuum suction nozzle decreases in diameter as the electronic component becomes smaller.

Patent Document 1: Japanese Unexamined Patent Publication (Kokai) No. 2-90700
Patent Document 2 Japanese Unexamined Patent Publication (Kokai) No. 11-26933
Patent Document 3: Japanese Unexamined Patent Publication (Kokai) No. 11-99426
Patent Document 4: Japanese Unexamined Patent Publication (Kokai) No. 4-365579

Disclosure of the Invention

Problems to be Solved by the Invention

However, the suction nozzle installed on the chip component mounting apparatus described in Patent Document 1 employs a material such as ceramics having high wear resistance in the portion of the suction nozzle that suctions the chip component. This constitution results in less wearing of the suction nozzle at the tip end thereof, thus providing an advantage with regard to maintenance. However, the constitution of simply using a material such as ceramics having high wear resistance in the tip end portion of the suction nozzle leaves such a problem unsolved as slippage occurs between the chip component and the contact surface of the suction nozzle when the chip component mounting operation is carried out at a higher speed, thus resulting in positional deviation of suctioning, and stable accuracy cannot be achieved in mounting the chip component.

In the suction nozzle described in Patent Document 3, air leakage through minute gaps between the electronic component and the suction surface can be minimized, while a proper level of frictional resistance with the electronic component is provided. This constitution increases the suction force and prevents the electronic component from undergoing positional deviation or dropping when the vacuum suction nozzle is moving at a high speed. However, there is such a problem that the suction surface processed by shot blast is covered by sharp particles, that may come off the surface under the impact load during suctioning or the end face may be chipped.

Further in the suction nozzle described in Patent Document 4, negative pressure is generated in the fluid passage by the Bernoulli's effect by flowing a gas at a high speed through the fluid passage formed to penetrate from the suction orifice to the circumferential surface of the nozzle body in the tip end of the nozzle body, so that a work can be held with a suction force that is increased by the negative pressure over the conventional suction nozzle of the same diameter. However, there is such a problem that the electronic component is likely to be displaced due to vibration and slippage during suction operation, caused by a gas flowing at a high speed, and as a result, high-speed mounting cannot be achieved.

The present invention has been devised to solve the problems described above, and has an object of providing a vacuum suction nozzle that experiences less wear and is capable of bearing the impact load during suctioning operation, and allows for high-speed and high-density mounting operation in which an object to be mounted can be surely picked up without undergoing positional deviation or dropping due to slipping, and the suctioned object is quickly mounted on a circuit board and is released.

Recently in such a process as a vacuum suction nozzle is caused to move at a high speed to pick up an electronic component from a tray and carry the electronic component to a circuit board to mount it on the circuit board, the circuit board and the electronic component to be mounted thereon are becoming increasingly smaller in size, and the number of electronic components to be mounted has been increasing. Therefore it is called for to shorten the time required for the vacuum suction nozzle to pick up an electronic component and mount it on a predetermined position of a circuit board. In the trend toward smaller vacuum suction nozzle as the electronic components become smaller in size and lighter in weight, it is also required to surely pick up the electronic component without undergoing a positional deviation, slipping or dropping, and to release the electronic component quickly from the suction surface, thereby to increase the speed of mounting.

Particularly in the constitution disclosed in Patent Document 1 where a material such as ceramics having high wear resistance is simply used in the tip end portion of the suction nozzle whereon a chip component is suctioned, there has been such a problem that slippage occurs between the chip component and the contact surface of the suction nozzle when the mounter is operated at a higher speed, and stable accuracy cannot be achieved in mounting the electronic component on the circuit board.

In order to solve this problem, Patent Document 2 discloses such a constitution as the electronic component can be suppressed from slipping by forming the nozzle body from a base material having high wear resistance and high impact resistance to ensure durability, and providing a contact material, having higher coefficient of friction than that of the base material, on the component suction surface of the suction nozzle. However, this constitution has such a problem that suppressing the electronic component from slipping results in a longer time taken to release the electronic component from the suction surface after placing the electronic component at the mounting position on the circuit board.

The constitution disclosed in Patent Document 3 enables it to reliably hold the electronic component without allowing positional deviation of the electronic component when moving the suction nozzle at a high speed, by forming the suction surface by applying shot blast to the suction surface of the suction nozzle, or depositing hard particles measuring 0.5 to 2 μm in diameter at least on the tip end face to form the suction surface having surface roughness of 0.5 to 5 μm at the maximum (Ry). However, since the suction surface is made rough by forming a large number of dents left by machining operation without straight streaks that extend in one direction, it becomes difficult for air to flow when the gap between the suction surface and the object becomes smaller, thus causing the pressure of air in the gap to increase sharply. Thus such problems remain that the electronic component picked up undergoes positional deviation, or a longer time is taken to release the electronic component from the suction surface after placing the electronic component at the mounting position on the circuit board.

The constitution disclosed in Patent Document 4 has such a problem that the electronic component is caused to vibrate by air flow and thus to be displaced on the suction surface, since the electronic component is held by flowing a gas at a high speed through the fluid path formed to communicate with the suction surface of the suction nozzle.

An object of the present invention is to provide a vacuum suction nozzle having high efficiency of transfer that is capable of picking up an object onto the tip end thereof by vacuum suction without positional deviation, moving the electronic component without slipping or dropping, and shortening the time required to release the electronic component from the suction surface at the destination.

Means for Solving the Problems

A first vacuum suction nozzle of the present invention includes a suction surface configured to vacuum suction an object thereon and a suction orifice configured to communicate with the suction surface, wherein a tip end portion including the suction surface is formed from ceramics, the ceramics contains a main component and a second component, the second component having a mean crystal grain size which is larger than a mean crystal grain size of the main component, and crystal grains of the second component protrude more than crystal grains of the main component on the suction surface.

A second vacuum suction nozzle of the present invention is **characterized in that** a portion around the suction orifice of the suction surface protrudes and the suction surface is curved toward an outside.

Effects of the Invention

According to the vacuum suction nozzle of the first embodiment of the present invention, the ceramics of the suction surface contains the main component and the second component that has a mean crystal grain size larger than the mean crystal grain size of the main component, and the crystal grains of the second component protrude more than the crystal grains of the main component on the suction surface. With this constitution, when an object is picked up by vacuum, the crystal grains of the second component protruding from the suction surface and minute recesses existing in the surface of the object loosely lock with each other. As a result, it is made possible to surely hold the object without undergoing positional deviation due to slipping, and the object can be carried and mounted without dropping. Also because there is the air flow passage between the crystal grains of the second component and the recess in the suction surface, the suction surface does not stick to the object, and the object can be released without taking any time when suction of air through the suction orifice is stopped after mounting.

Therefore, according to the vacuum suction nozzle of the first embodiment of the present invention, the resultant vacuum suction nozzle experiences less wear and is capable of bearing the impact load during suctioning operation, and allows for high-speed and high-density mounting operation in which the object can be reliably picked up without undergoing positional deviation or dropping due to slipping, and the object suctioned thereon is quickly mounted on a circuit board and released.

According to the vacuum suction nozzle of the second embodiment of the present invention, the suction surface whereon the object is suctioned by vacuum is formed from ceramics, while a portion around the suction orifice of the suction surface protrudes and the suction surface is curved toward the outside. With this constitution, since the air flow from the side face of the vacuum suction nozzle toward the suction orifice is not disturbed when the object is suctioned onto the suction surface, the object can be suctioned precisely onto the predetermined position of the suction surface. When the object is released from the suction surface, the object does not stick to the suction surface since the vacuum suction nozzle has a continuous surface that changes smoothly from the side face of the suction nozzle toward the suction surface. Also the object can be released in a short period of time when suction of air through the suction orifice is stopped for releasing the object after mounting.

Therefore, according to the vacuum suction nozzle of the second embodiment of the present invention, it is possible to provide a vacuum suction nozzle having high efficiency of transfer that is capable of picking up an object onto the tip end thereof by vacuum suction without positional deviation of the object, moving the electronic component without slipping or dropping, and shortening the time required to release the object from the suction surface at the destination.

Brief Description of the Drawings

Fig. 1 shows an example of the constitution in which a vacuum suction nozzle of the present invention is incorporated into a holding member of an electronic component mounter, Fig. 1(a) shows a perspective view thereof and Fig. 1(b) shows a longitudinal sectional view thereof.

Fig. 2 is a schematic diagram showing the constitution of the electronic component mounting apparatus that mounts chip electronic component on a circuit board by using the electronic component mounter having the vacuum suction nozzle of the present invention.

Fig. 3 is an enlarged schematic view of the suction surface of the vacuum suction nozzle 1 of the present invention and a part of the surface of the electronic component suctioned thereon.

Fig. 4 is a perspective view showing an example of the constitution of the continuous surface that changes smoothly toward the suction face of the vacuum suction nozzle of the present invention.

Fig. 5 is a sectional view taken along lines A-A' in Fig. 4 of the vacuum suction nozzle 1 of the present invention.

Fig. 6 is a perspective view showing an example of the vacuum suction nozzle having a plurality of grooves that run from the side face of the vacuum suction nozzle of the present invention toward the suction surface.

Fig. 7 is a sectional view taken along lines A-A' in Fig. 6 of the vacuum suction nozzle of the present invention.

Fig. 8 is a front view showing a method for measuring the electrical resistance between the front end and rear end of the vacuum suction nozzle of the present invention.

Fig. 9 shows an example of the constitution of the vacuum suction nozzle as incorporated into a holding member of the electronic component mounter of the prior art, Fig. 9(a) shows a perspective view thereof and Fig. 9(b) shows a longitudinal sectional view thereof.

Fig. 10 is a schematic diagram showing the constitution of an electronic component mounting apparatus that uses an electronic component mounter equipped with a vacuum suction nozzle for mounting chip electronic components on a circuit.

Fig. 11 is a plan view of the suction surface of the vacuum suction nozzle of Example 4.

Description of Reference Numerals

1:       Vacuum suction nozzle
2:       Suction surface
3:       Suction orifice
4:       Conical portion
5:       Cylindrical portion
6:       Head
7:       Continuous surface
8:       Grooves
10:      Holding member
11:      Socket

12: Suction orifice
14: Electronic component mounter
15: Electronic component
15a: Minute recesses
16: Tray
17: Light
18: CCD camera
19: Image analyzing apparatus
22: Crystal grains of second component
23: Crystal grains of main component

Best Mode for Carrying Out the Invention

[First Embodiment]

An example of the vacuum suction nozzle according to first embodiment of the present invention will be described below.

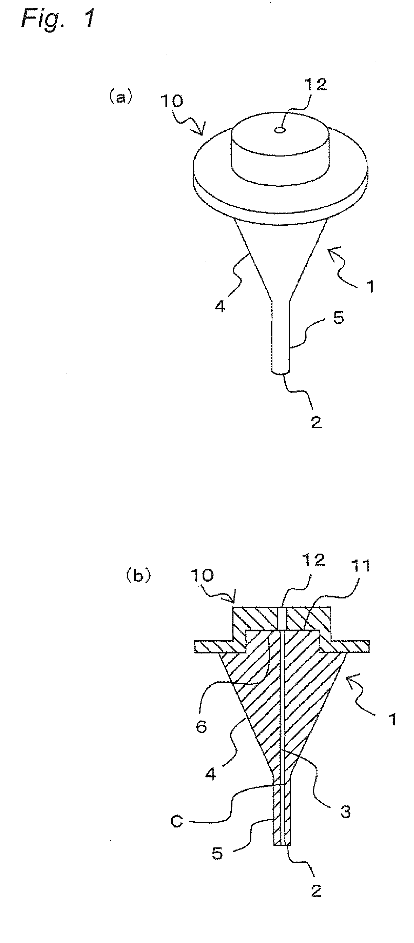

Fig. 1 shows an example of the constitution in which a vacuum suction nozzle according to the first embodiment of the present invention is incorporated into a holding member of an electronic component mounter, Fig. 1(a) shows a perspective view thereof and Fig. 1(b) shows a longitudinal sectional view thereof.

As shown in Fig. 1, the vacuum suction nozzle 1 according to the first embodiment of the present invention has a cylindrical portion 5 having a suction surface 2 formed on the tip end face for holding an electronic component by vacuum suction, a conical portion 4 that tapers off toward the cylindrical portion 5 and is provided on the side of the cylindrical portion 5 opposite to the suction surface 2, and a head 6 provided on the end face of the base where the conical portion 4 opposes the suction surface 2. The inner hole penetrating the cylindrical portion 5 and opening in the suction surface 2 extends to the conical portion 4 and the head 6 and opens in the surface of the head 6, thus constituting the suction orifice 3.

The suction surface 2 can be formed in any shape that matches the shape of the object, such as oval, rectangle, polygon, etc. However, the suction surface 2 preferably a round shape having no corner on the outside with the cylindrical portion 5 having uniform wall thickness, in consideration of the requirements to have mechanical strength enough to bear the impact load during suctioning, and suppress scratch and other flaws from occurring due to contact with the object.

The holding member 10 wherein the vacuum suction nozzle 1 is to be assembled has a socket 11 that engages the head 6 of the vacuum suction nozzle 1, and a suction orifice 12 that communicates with the suction orifice 3. The vacuum suction nozzle 1 is installed on the electronic component mounter by fitting the head 6 of the vacuum suction nozzle 1 in the socket 11 of the holding member 10.

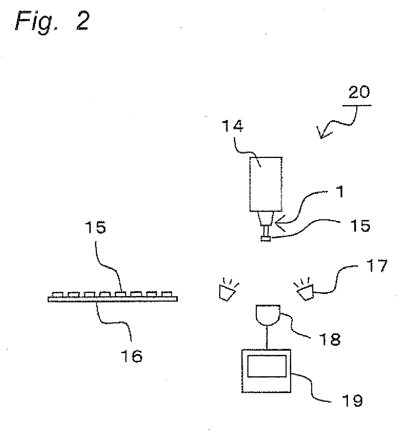

Fig. 2 schematically shows the constitution of an electronic component mounting apparatus that mounts chip electronic components on a circuit board by using the electronic component mounter having the vacuum suction nozzle 1 of the present invention.

The electronic component mounting apparatus 20 of the first embodiment shown in Fig. 2 includes the electronic component mounter 14 having the vacuum suction nozzle 1 with electronic component 15 suctioned thereon, a tray 16 carrying the electronic components 15 not mounted yet arranged thereon, a light 17 that directs light to the electronic component 15 suctioned thereon by the vacuum suction nozzle 1, a CCD camera 18 that captures the image of the electronic component 15 illuminated with the light, and an image analyzing apparatus 19 that applies image analysis to the image captured by the CCD camera 18.

In the electronic component mounting apparatus 20, the electronic component mounter 14 having the vacuum suction nozzle 1 moves to the tray 16 and picks up the electronic component 15 placed on the tray 16. The light 17 directs light to the electronic component 15 suctioned thereon by the vacuum suction nozzle 1 during the movement to a circuit board not shown in the drawing, and the CCD camera 18 captures the image of the electronic components 15 illuminated with the light. The image captured by the CCD camera 18 is analyzed by the image analyzing apparatus 19 to determine the position and orientation of the electronic component 15, then the position of the electronic component mounter 44 is corrected and the vacuum suction nozzle 1 carrying the electronic component 15 is moved to a predetermined position of the circuit board thereby to mount the electronic component 15 on the circuit board.

In the vacuum suction nozzle 1 of the present invention, it is important that the suction surface 2 whereon the electronic component 15 is suctioned by vacuum is formed from ceramics, the suction orifice 3 is formed in the suction surface 2, the ceramics of the suction surface 2 contains a main component, and a second component that has a mean crystal grain size larger than the mean crystal grain size of the main component, and the crystal grains of the second component protrude more than the crystal grains of the main component on the suction surface 2.

The term "main component" as used herein refers to a component contained in the ceramics with a proportion of 50% by mass or more based on 100% by mass of all components that constitute the ceramics. It is preferable that a kind of ceramics having high wear resistance and high mechanical strength required for the vacuum suction nozzle 1 is used as the main component.

The second component refers to crystal grains having a mean crystal grain size larger than the mean crystal grain size of the main component, and the crystal grains of the second component protrude more than the crystal grains of the main component on the suction surface 2. This can be checked by taking photograph of a section of the suction surface 2 by using a scanning electron microscope. When there exist a plurality of different kinds of crystal grains that protrude more than the crystal grains of the main component, the second component is determined by measuring the difference between the apex of the crystal grain of each component and the apex of crystal grains of the main component that adjoins the crystal grain at some ten points, and determining the component having the largest mean protruding height as the second component.

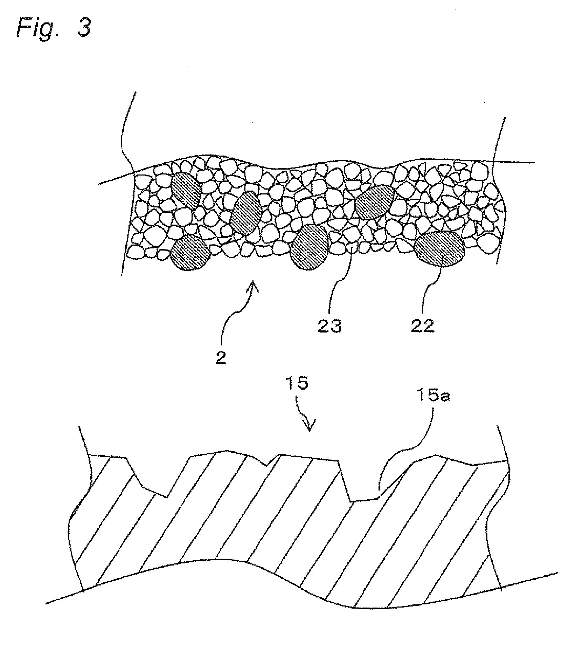

Fig. 3 is an enlarged schematic view of the suction surface of the vacuum suction nozzle 1 of the present invention and a part of the surface of the electronic component suctioned thereon. The top diagram shows an example of the constitution of the crystal grains 23 of the main component and the crystal grains 22 of the second component on the suction surface 2 of the vacuum suction nozzle 1. The bottom diagram shows an example of the surface of the electronic component. Like an example shown in Fig. 3, in the vacuum suction nozzle 1 of the present invention, the crystal grains 22 of the second component that have mean crystal grain size larger than that of the crystal grains 23 of the main component protrude more than the crystal grains 23 of the main component on the suction surface 2, and the electronic component 15 suctioned thereon has minute recesses 15a in the surface thereof.

Since the crystal grains 22 of the second component that has a mean crystal grain size larger than that of the crystal grains 23 of the main component protrude more than the crystal grains 23 of the main component on the suction surface 2, when the electronic component 15 is picked up by vacuum, the crystal grains 22 of the second component protruding from the suction surface and the minute recesses 15a existing in the surface of the electronic component 15 loosely lock with each other. The state that "the crystal grains 22 of the second component and the recesses 15a existing in the surface of the electronic component 15 loosely lock with each other" is such a situation as the crystal grains 22 of the second component mesh with the recesses 15a in a hitched manner, and there is the air flow passage between the crystal grains 22 of the second component and the recesses 15a. As a result, it is made possible to reliably hold the electronic component 15 without positional deviation thereof due to slipping or the like, and the electronic component 15 can be carried and mounted without dropping. Also because there is the air flow passage between the crystal grains 22 of the second component and the recesses 15a when the electronic component 15 is suctioned thereon, the electronic component 15 does not stick to the suction surface 2, and the electronic component 15 can be released without taking any time when suction of air through the suction orifice 3 is stopped for releasing the electronic component 15 after mounting.

In order to achieve the effect described above, it is preferable that mean protruding height of the crystal grains 22 of the second component is not less than 1 $\mu$m nor more than 7 $\mu$m as determined from the image captured by the scanning electron microscope. When mean protruding height of the crystal grains 22 of the second component is less than 1 $\mu$m, it is difficult for the crystal grains 22 of the second component to hitch onto the recesses 15a, resulting in weak engagement and the possibility of positional deviation of suctioning due to slipping increases. When mean protruding height of the crystal grains 22 of the second component is more than 7 $\mu$m, the crystal grains 22 of the second component may be caught in the recesses 15a thus making it difficult to release the electronic component 15 during mounting, thus increasing the probability of a trouble called carry-back.

The suction surface 2 where the crystal grains 22 of the second component having a mean crystal grain size larger than that of the crystal grains 23 of the main component protrude more than the crystal grains 23 of the main component can be obtained by causing the crystal grains 22 of the second component protrude by taking advantage of the difference in machining rate between the main component and the second component in machining process such as chemical etching or ion milling, or by depositing the second component on the suction surface 2 of a green compact of the vacuum suction nozzle 1 and firing. While protrusions and recesses can be formed on the suction surface 2 also by a mechanical machining process, protrusions formed by a mechanical machining process are sharp and likely to chip off at the tip. As a result, such troubles may occur as the crystal grains of the second component are caught in the recesses 15a of the electronic component 15 thus making it difficult to release the electronic component 15 during mounting, or the protrusions are chipped off and cannot be fitted in the recesses 15a, thus resulting in positional deviation of suctioning. According to the present invention, in contrast, since the protrusions are formed by causing the crystal grains 22 of the second component to protrude, the crystal grains 22 of the second component to be fitted in the recesses 15a of the electronic component 15 are rounded at the tip are less likely to be chipped, thus enabling it to carry out the operation of stably suctioning and mounting the electronic component 15 over a long period of time.

The vacuum suction nozzle 1 of the present invention is preferably formed from a material containing zirconia as the main component.

The term "zirconia" as used herein includes zirconia containing a stabilizing agent. A material consisting of zirconia containing a stabilizing agent as the main component has good mechanical properties such as strength and toughness, and high wear resistance, and enables it to make the cylindrical portion 5 smaller in diameter to meet the requirement of smaller electronic component 15. Such a material enables it to make the vacuum suction nozzle 1 that can be used over a long period of time, since chipping and damage are less likely to occur after repetitive operations of suctioning and mounting of electronic component 15.

The stabilizing agent added to the zirconia ceramics may be yttria, ceria, magnesia or the like. Zirconia having sufficiently high strength for practical use can be obtained by containing 2 to 5 mol% of such a stabilizing agent. In case the mean crystal grain size of zirconia is from 0.3 to 1 $\mu$m, it is possible to obtain vacuum suction nozzle 1 that is less likely to be break under the impact load during suctioning the suction surface 2 has a small size. More preferably, when the mean crystal grain size of zirconia is from 0.3 to 0.8 $\mu$m, it is possible to decrease the mean crystal grain size of the second component having larger mean crystal grain size than that of the main component. Accordingly, it is possible to prevent positional deviation by loose locking of crystal grains 22 as the secondary component even to the minute recesses 15a having a small opening size existing on a surface of the electronic component 15 to be suctioned thereon.

The vacuum suction nozzle 1 of the present invention is preferably formed from the material containing alumina as the second component.

When the second component is alumina, since alumina has high hardness and wear due to contact with the electronic component 15 to be suctioned thereon, thus making it possible to enhance durability of the suction surface 2. In case that alumina has a mean crystal grain size larger than that of the main component and the crystal grains 22 of the alumina protruded more than the crystal grains 23 of the main component on the suction surface 2, other components may be added in the amount larger than that of the second component.

Furthermore, it is preferred that the vacuum suction nozzle 1 of the present invention is formed from the material containing, as the second component, any one of zinc oxide, iron oxide, titanium carbide and titanium nitride.

In case that the second component is any one of zinc oxide, iron oxide, titanium carbide and titanium nitride, electrical conductivity is imparted to the vacuum suction nozzle 1. Therefore, it is possible to prevent the vacuum suction nozzle 1 from being charged with static electricity generated through friction with air when the vacuum suction nozzle 1 moves at a high speed. In case that the second component is any one of titanium carbide and titanium nitride, since the second component has high hardness, it is possible to further improve wear resistance of the suction surface 2 and to enhance durability.

The vacuum suction nozzle 1 of the present invention preferably contains a conductivity imparting agent. While the vacuum suction nozzle 1 of the present invention may have either insulating or semi-conductive property, the vacuum suction nozzle can be made semi-conductive by adding a conductivity imparting agent even when the main component or the second component is an insulating ceramic material.

While an insulating ceramic material can be made by using zirconia as the main component and alumina as the second component, a reasonable level of electrical conductivity can be obtained by adding a conductivity imparting agent such as iron oxide, titanium oxide or zinc oxide. Using this material makes it possible to make the vacuum suction nozzle 1 that is less likely to break even when the cylindrical portion 5 is smaller in diameter and has a reasonable level of electrical conductivity. While alumina is an insulating ceramics, it is low-cost and has high wear resistance. Thus a material having a reasonable level of electrical conductivity can be made by using alumina as the main component and titanium carbide or titanium nitride as the second component and the conductivity imparting agent. Thus using this material makes it possible to make the vacuum suction nozzle 1 that has high wear resistance and a reasonable level of electrical conductivity.

When the vacuum suction nozzle 1 of the present invention has semi-conductive property, it is preferable that a value of an electrical resistance of the vacuum suction nozzle 1 over the entire length thereof, namely electrical resistance between the front end and rear end of the vacuum suction nozzle 1 is not less than $10^3$ $\Omega$ nor more than $10^{11}$ $\Omega$. This is because this level of electrical resistance makes it possible to decrease the probability of such a trouble to occur as the vacuum suction nozzle 1 is charged with static electricity generated through friction with air when the vacuum suction nozzle 1 moves at a high speed, and electric discharge occurs when the electronic component 15 is suctioned thereon, thus resulting in electrostatic breakdown. It also enables it to prevent the electronic component 15 from being moved or blown off by the repulsive force of static electricity.

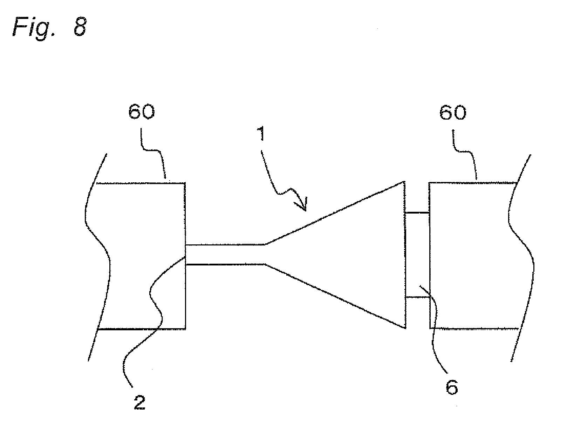

Fig. 8 schematically shows a method of measuring the electrical resistance between the front end and rear end of the vacuum suction nozzle 1, depicting an electrode 60 put into contact with the suction surface 2 at the tip end of the vacuum suction nozzle 1, and another electrode 60 put into contact with the end face of the head 6 at the rear end. The electrodes 60, 60 are connected to a resistance meter (not shown). The electrical resistance between the front end and rear end of the vacuum suction nozzle 1 can be measured by applying a voltage across the electrodes 60, 60 disposed on the front end and the rear end of the vacuum suction nozzle 1. The voltage applied for the measurement may be set in accordance with the shape and material of the vacuum suction nozzle 1 and the level of resistance, while about 10 to 1,500 V may be employed.

The vacuum suction nozzle 1 of the present invention preferably has a dark color tone.

When the electronic component mounter 14 equipped with the vacuum suction nozzle 1 having a dark color tone is used in the electronic component mounting apparatus 20 of the example shown in Fig. 2, the electronic component 15 suctioned by the vacuum suction nozzle 1 is shown against the background of the vacuum suction nozzle 1 having a dark color tone in the image captured with the CCD camera 18 by illuminating the electronic component 15 by the light 17, so that the electronic component 15 which usually has white, silver or grey color can be easily distinguished, thus clear profile of the electronic component 15 is obtained. As a result, possibility of positional deviation in mounting due to erroneous recognition of position or angle or improper correction can be decreased.

The term "dark color tone" used herein means a blackish, dark brownish, dark greenish, dark bluish color tone or the like, and is preferably a blackish color tone so as to obtain the above high effect. Examples of the coloring agent include iron oxide, titanium oxide, cobalt oxide, chromium oxide and nickel oxide in zirconia ceramics. Iron oxide is preferred among these coloring agents because it is likely that a blackish color tone is obtained. It is also possible to obtain a dark color tone by using a plurality of coloring agents. In the case of alumina ceramics, examples of the coloring agent include iron oxide, nickel oxide, titanium carbide and titanium nitride. Iron oxide and titanium carbide are preferred among these coloring agents because a blackish color tone is obtained. Since the coloring agents described above can impart electrical conductivity, the additive amount may be adjusted so as to obtain a vacuum suction nozzle 1 which exhibits a color tone that makes it easier to distinguish the electronic component 15, or a preferable resistance value.

A method for manufacturing a vacuum suction nozzle 1 made of ceramics of the present invention will be described below.

It is possible to use, as ceramics that constitute the vacuum suction nozzle 1 of the present invention, known materials such as zirconia, alumina and silicon carbide each containing a stabilizing agent.

For example, a material prepared by mixing 90% by mass of yttria-stabilized zirconia with 10% by mass of alumina as the second component was charged into a ball mill together with a solvent, and then crushed to obtain a slurry. Using a spray dryer, this slurry is spray-dried to prepare granular materials. Alternately, zirconia and alumina were charged into separate ball mills and then crushed so as to adjust the mean crystal grain size and, after completion of crushing, a slurry of zirconia and a slurry of alumina are mixed and then spray-dried using a spray dryer, thus making it possible to obtain granular materials.

Then the granules and the thermoplastic resin are charged into a kneader, and kneaded, while heating. The resultant green body is charged into a pelletizer to make pellets used as the raw material for injection molding process. The thermoplastic resin to be charged into the kneader may be prepared by adding about 10 to 25% by mass of an ethylene-vinyl acetate copolymer, polystyrene or an acrylic resin to 100% by mass of the granules. The kneader may be set at a temperature from 140 to 180°C, and other kneading conditions such as pressure may be determined according to the kind of a ceramic material and the kind of a thermoplastic resin to be used.

The pellets obtained are charged into an injection molding machine, to obtain a green compact that would be turned into the vacuum suction nozzle 1, while cutting off a runner formed on the green compact from excessive material that has solidified, as required.

When oxide-based ceramics is used so as to contain zirconia as the main component and alumina as the second component, firing condition may be set such that maximum temperature is from 1,350°C to 1,600°C, and the maximum temperature is held for a period of 1 to 5 hours in air atmosphere. When non-oxide ceramics is used containing titanium carbide or titanium nitride as the second component, it may be fired at maximum temperature of 1,450 to 1,700°C in vacuum or inactive gas atmosphere such as argon or helium, while holding the maximum temperature for a period of 1 to 5 hours. In the case of titanium nitride, it may be fired in nitrogen atmosphere.

Then the crystal grains 22 of the second component are caused to protrude more than the crystal grains 23 of the main component by applying machining process such as chemical etching or ion milling to the suction surface 2, thereby to obtain the vacuum suction nozzle 1 of the present invention. The machining process may also be applied to the suction surface 2 that has been made flat by mirror-finish operation. The vacuum suction nozzle 1 of the present invention may also be made by depositing the second component on the suction surface 2 of the green compact that would become the vacuum suction nozzle 1.

The vacuum suction nozzle 1 having electrical conductivity and blackish color so that the electronic component 15 can be easily distinguished is preferably made by, for example, containing 65% by mass of zirconia as the main component and 35% by mass of iron oxide as the second component, or containing 30% by mass of iron oxide as the second component with 3% by mass of cobalt oxide and 2% by mass of chromium oxide added.

In the vacuum suction nozzle 1 obtained as described above, the crystal grains 22 of the second component having larger mean crystal grain size than the crystal grains 23 of the main component protrude more than the crystal grains 23 of the main component. With this constitution, when the electronic component is suctioned thereon, the crystal grains 22 of the second component that protrude and the minute recesses 15a provided with the surface of the electronic component 15 loosely lock with each other. As a result, it is made possible to surely hold the electronic component 15 without undergoing positional deviation of suctioning due to slipping, and therefore the electronic component 15 can be carried and mounted without dropping. Also because there is the air flow passage in the suction surface 2 between the crystal grains 22 of the second component and the recess 15a, the electronic component 15 does not stick to the suction surface 2. And the electronic component 15 can be released without taking any time when suction of air through the suction orifice 3 is stopped for releasing the electronic component 15 after mounting, thus providing for speed-up of the mounting operation.

By making the vacuum suction nozzle 1 electrically conductive through addition of the second component or the other component, it is made possible to prevent the vacuum suction nozzle 1 from being charged with static electricity generated through friction with air when the vacuum suction nozzle 1 moves at a high speed. It also makes it possible to decrease the possibility of electrostatic breakdown occurring due to electric discharge taking place when the electronic component 15 is suctioned thereon, and prevent the electronic component 15 from being moved or blown off by the repulsive force of static electricity.

In the vacuum suction nozzle 1 rendered a color that makes it easier to distinguish the electronic component 15 by adding the second component or the other component, clear profile of the electronic component 15 can be captured by the CCD camera 18, so that possibility of positional deviation when mounting due to erroneous recognition of position or angle or improper correction can be decreased and density of mounting can be increased.

[Second Embodiment]

A second embodiment of the present invention will be described below.
Fig. 1 shows an example of the constitution having the vacuum suction nozzle incorporated into the holding member of the electronic component mounter, Fig. 1(a) shows a perspective view thereof and Fig. 1(b) shows a longitudinal sectional view of Fig. 1(a).

The vacuum suction nozzle 1 shown in Fig. 1 has the cylindrical portion 5 having the suction surface 2 formed on the tip end face for holding the electronic component (not shown) by vacuum suction, the conical portion 4 that tapers off toward the cylindrical portion 5 and is provided on the side of the cylindrical portion 5 opposite to the suction surface 2, and the head 6 provided on the end face of the base where the conical portion 4 opposes the suction surface 2. The inner hole penetrating the cylindrical portion 5 and opening in the suction surface 2 extends to the conical portion 4 and the head 6 and opens in the surface of the head 6, thus constituting the suction orifice 3.

The holding member 10 having the socket 11 that engages the head 6 and the suction orifice 12 for communicating with the suction orifice 3, is installed by fitting the head 6 of the vacuum suction nozzle 1 in the socket 11, and the vacuum suction nozzle 1 is installed on the electronic component mounter (not shown) via the holding member 10.

Fig. 2 schematically shows the constitution of the electronic component mounting apparatus that mounts chip electronic component on a circuit board by using the electronic component mounter having the vacuum suction nozzle 1 of the present invention.

The electronic component mounting apparatus 20 shown in Fig. 2 is composed of the vacuum suction nozzle 1 installed on the electronic component mounter 14, the tray 16 carrying the electronic component 15 arranged thereon, the light 17 that directs light to the electronic component 15 suctioned thereon by the vacuum suction nozzle 1, the CCD camera 18 that receives the reflected light of the light 17, and the image analyzing apparatus 19 that applies image analysis to the reflected light (image) received by the CCD camera 18.

In the electronic component mounting apparatus 20, the vacuum suction nozzle 1 moves to the tray 16 and suctions the electronic component 15 placed on the tray 16. Then the light 17 directs light to the electronic component 15 suctioned thereon by the vacuum suction nozzle 1, and the CCD camera 18 captures the light that has reflected on the body and electrodes of the electronic components 15. The image captured by the CCD camera 18 is analyzed by the image analyzing apparatus 19 to determine the position of the electronic component 15, then the vacuum suction nozzle 1 carrying the electronic component 15 is moved to a predetermined position of the circuit board (not shown) based on the data, thereby to mount the electronic component 15 on the circuit board.

In the vacuum suction nozzle 1 of the present invention, it is important that the suction surface 2 whereon the object is suctioned by vacuum is provide at the tip end, the portion having the suction surface 2 is formed from ceramics, the suction orifice 3 is formed on the suction surface 2, portion of the suction surface 2 near the suction orifice 3 protrudes, and the suction surface 2 curves from the circumferential surface to the side face, namely there is a continuous surface 7 that changes smoothly from the side face of the cylindrical portion 5 near the suction surface 2 toward the suction surface 2.

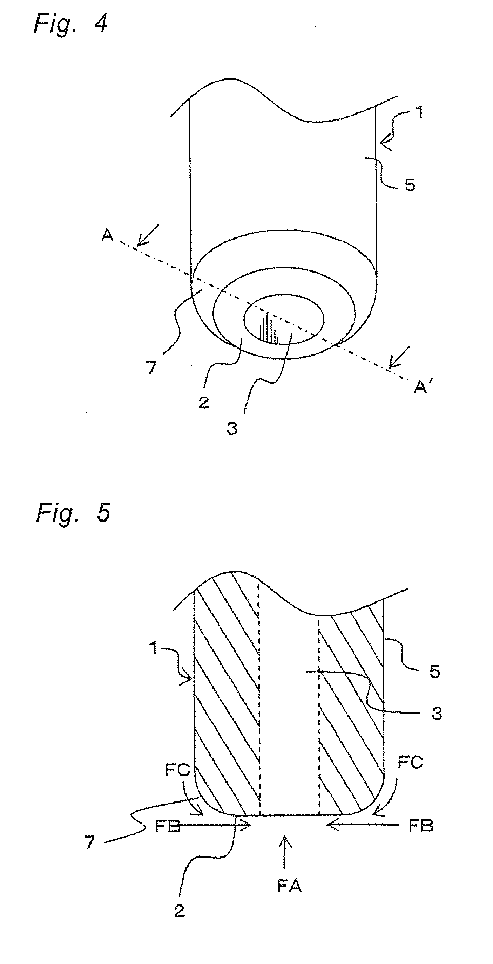

Fig. 4 is a perspective view showing an example of constitution of the continuous surface that is curved smoothly toward the suction face of the vacuum suction nozzle of the present invention.

The vacuum suction nozzle 1 comprises: the suction surface 2 configured to vacuum suction an object thereon; and the suction orifice 3 provided at the tip end of the cylindrical portion 5, and the continuous surface 7 that is curved smoothly from the side face of the cylindrical portion 5 near the suction surface 2 toward the suction surface 2.

The continuous surface 7 shown in Fig. 4 depicts a case where the continuous surface 7 that is curved smoothly from the side face of the cylindrical portion 5 near the suction surface 2 toward the suction surface 2 is formed over the entire circumference of the suction surface 2. The continuous surface 7 may not necessarily be formed over the entire circumference of the suction surface 2, and may be divided into two to eight segments of continuous surface along the circumference of the suction surface 2.

When it is attempted to suction an object (not shown) by vacuum suctioning through the suction orifice 3 of the vacuum suction nozzle 1 as shown in Fig. 5 in the sectional view taken along lines A-A' in Fig. 4 of the vacuum suction nozzle 1 of the present invention, there arise an air flow FA flowing in a direction perpendicular to the suction surface 2 toward the suction orifice 3 of the suction surface 2, an air flow FB flowing in a direction parallel to the suction surface 2, and an air flow FC flowing from the side face of the cylindrical portion 5 through the continuous surface 7 and turning into the direction of the suction surface 2 so as to join the air flow FB. At this time, pressure between the suction surface 2 and the object (not shown) is decreased by vacuum suction, so that the object is attracted toward the suction surface 2. At a time immediately before the time when the object touches the suction surface 2, the distance between the suction surface 2 and the object further decreases and the flow of air is almost dominated by the air flow FB, so that the air flow FC is taken in by the air flow FB due to the Venturi effect which is caused by an increasing velocity of air flow that decreases the pressure and takes in the surrounding air. However, since the air flow FC flows along the continuous surface 7 that changes smoothly toward the suction surface 2 and smoothly joins the air flow FB while flowing in substantially the same direction as the air flow FB, the air flow FB is hardly disturbed substantially at the confluence. As a result, the object is held in stable posture throughout the period from the time when it is picked up from the tray to the time it is suctioned onto the suction surface 2, so that the object can be suctioned at the predetermined position of the suction surface 2.

The vacuum suction nozzle 1 of the example shown in Fig. 4 is particularly suitable as it can be applied to objects of various shapes, because air residing on the side face of the cylindrical portion 5 of the vacuum suction nozzle 1 forms the air flow FC and smoothly joins the air flow FB while flowing evenly in all directions toward the suction orifice 3.

It is necessary to form the continuous surface 7 so that the air flow FC flows along the continuous surface 7 and smoothly joins the air flow FB and is taken in thereby. Specifically, such a constitution of the example shown in Fig. 4 may be employed as radius d of the suction orifice 3, radius e of the suction surface 2 and radius f of the cylindrical portion 5 satisfy relationships $1.2d \leq e$ and $1.1e \leq f$ when the suction surface 2 and the suction orifice 3 have round shape having centers at the same point, the cylindrical portion 5 also has round cross section, and the curve of the longitudinal section of the continuous surface 7 is constituted from arc. It is preferable to satisfy $1.2d \leq e$ because it stabilizes the posture of the object when it is suctioned onto the suction surface 2 and maintains the strength of the suction surface 2. It is preferable to satisfy $1.1e \leq f$ because it enables the air flow FC to smoothly join the air flow FB while keeping the area of the continuous surface 7. When set to satisfy $e < 1.2d$, area of the suction surface 2 becomes too small and the posture of the object when it is suctioned onto the suction surface 2 becomes unstable, strength of the suction surface 2 decreases, and thus possibility of damage increases. When set to satisfy $f < 1.1e$, the continuous surface 7 cannot be formed satisfactorily and the air flow at the confluence of the air flow FC and the air flow FB is disturbed, resulting in that an attitude of the suctioned object becomes unstable, and thus making it difficult to suction the object at the predetermined position.

In practice, since the optimum shape varies depending on the kind of object to be suctioned and the setting of the electronic component mounter, configurations of the suction surface 2 and the continuous surface 7 may be determined by conducting a suction test on a product.

In the vacuum suction nozzle 1 of the second embodiment of the present invention, it is important that it has the suction surface 2 whereon the object is suctioned by vacuum at the tip end, the portion that has the suction surface 2 is formed from ceramics, the suction orifice 3 is formed to communicate with the suction surface 2, and there are a plurality of grooves 8 formed on the circumference of the tip end (cylindrical portion 5) of the vacuum suction nozzle 1 to reach the suction surface 2, namely a plurality of grooves 8 are formed on the circumference of the suction surface 2 to run from the side face of the cylindrical portion 5 of the vacuum suction nozzle 1 toward the suction surface 2.

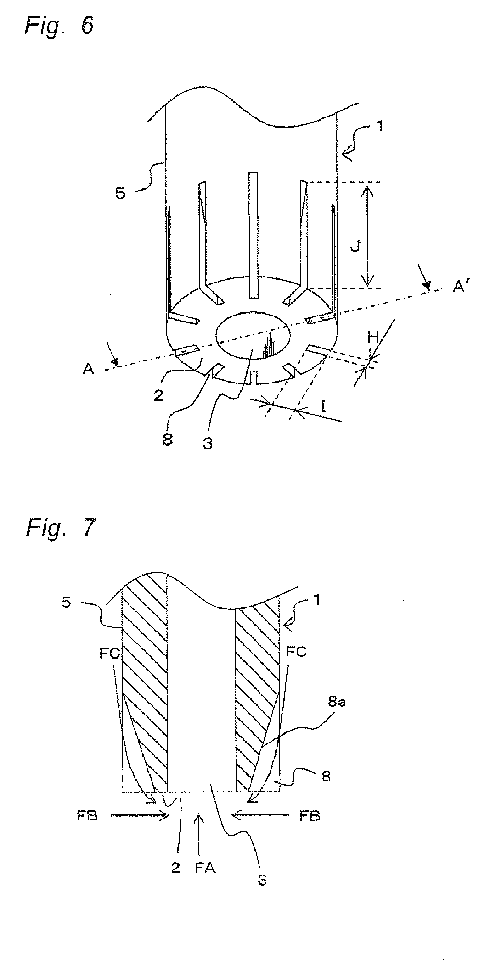

Fig. 6 is a perspective view showing an example of the vacuum suction nozzle having a plurality of grooves configured to extend from the side face of the vacuum suction nozzle of the present invention to the suction surface. In the example shown in Fig. 6, the suction surface 2 is formed on the tip end of the cylindrical portion 5 of the vacuum suction nozzle 1, and the suction orifice 3 is formed through the center of the suction surface 2. Formed on the circumference of the suction surface 2 of the vacuum suction nozzle 1 are ten grooves 8 so as to surround the suction surface 2 while extending from the side face of the cylindrical portion 5 of the vacuum suction nozzle 1 toward the suction surface 2, while depth of the grooves 8 gradually increases from the side face of the vacuum suction nozzle 1 toward the suction surface 2.

Fig. 7 is a sectional view taken along lines A-A' in Fig. 6 of the vacuum suction nozzle of the present invention.

When it is attempted to suction an object (not shown) by vacuum suctioning through the suction orifice 3 of the vacuum suction nozzle 1, there arise the air flow FA flowing in a direction perpendicular to the suction surface 2 toward the suction orifice of the suction surface 2, the air flow FB flowing in a direction parallel to the suction surface 2, and the air flow FC flowing from the side face of the cylindrical portion 5 through the groove 8 and turning into the direction of the suction surface 2 so as to join the air flow FB. At this time, pressure between the suction surface 2 and the object (not shown) is decreased by vacuum suction, so that the object is suctioned onto the suction surface 2. At a time immediately before the object touches the suction surface 2, the distance between the suction surface 2 and the object further decreases and the flow of air is almost dominated by the air flow FB, so that the air flow FC is taken in by the air flow FB due to the Venturi effect. However, since the air flow FC flows along the groove 8 that runs toward the suction surface 2 and smoothly joins the air flow FB while flowing in substantially the same direction as the air flow FB, the air flow FB is hardly disturbed substantially at the confluence. Also because posture of the object is stabilized during the period from the time it is picked up from the tray to the time it is suctioned onto the suction surface 2, the object can be suctioned at the predetermined position of the suction surface 2. Providing the grooves 8 also makes it easier for air to flow through the entire area of the suction surface 2 through the grooves 8 when the object is released, and therefore the object does not stick onto the suction surface 2. And the object can be released without taking any time when suction of air through the suction orifice 3 is stopped for releasing the object after mounting.

The width H of the groove 8 is preferably in a range from 0.1 to 1 mm. When the width H of the groove 8 is 0.1 mm or more, the air flow FC flows through the groove 8, and therefore the air flow FB is less likely to be substantially disturbed at the confluence with the air flow FB, thus providing a substantial effect of preventing positional deviation of the object. When the width H of the groove 8 is 1 mm or less, direction of the air flow FC in the groove 8 is stabilized, thus enabling it to decrease positional deviation of the object. when the width H of the groove 8 is less than 0.1 mm, the air flow FC flows less through the groove 8 in a situation substantially the same as a case without groove 8 in which the air flow is more likely to be disturbed and the effect of preventing positional deviation of the object decreases. In contrast, when the width H of the groove 8 is more than 1 mm, forming the grooves 8 is equivalent to providing steps which causes such a problem that the air flow FC is disturbed and positional deviation of the object is likely to occur.

It is also preferable to set the depth I of the groove 8 to 0.05 mm or more in areas where the grooves 8 and the suction surface 2 cross each other. When the depth I of the groove 8 is 0.05 mm or more in these areas, the air flow FB is less likely to be substantially disturbed at the confluence with the air flow FB, thus providing a substantial effect of preventing positional deviation of the object. When the depth I of the groove 8 is less than 0.05 mm, the effect of causing the air flow FC to flow through the groove 8 and smoothly join the air flow FB decreases in a situation substantially the same as a case without the groove 8. As a result, the air flows FB, FC are more likely to be disturbed and the effect of preventing positional deviation of the object decreases.

It is preferable that a ratio of the width H to the depth of the groove 8 satisfy a relationship H/2 ≤ I (H/I ≤ 2). When the depth I of the groove 8 is one half of width H or more, the air flow FC flows through the groove 8 and therefore the air flow FB is less likely to be substantially disturbed at the confluence with the air flow FB, thus providing a substantial effect of preventing positional deviation of the object. When the width H and depth I of the groove 8 satisfy a relationship H/2 > I (H/I > 2), the depth I is too small relative to width H, thus resulting in a situation substantially the same as a case without the groove 8. As a result, the air flows FB, FC are more likely to be disturbed and the effect of preventing positional deviation of the object decreases.

The length J of the groove 8 may be such that the air flow FC can be generated. Bottom of the groove 8 may either incline toward the suction orifice 3 on the side of the suction surface 2 as shown in Fig. 7, or have such a shape as that of the continuous surface 7 that changes smoothly as shown in Fig. 5.

In order to suppress air flow, other than the air flow FC that flows along the groove 8, from being generated in the vicinity of the circumference of the suction surface 2, it is preferable to dispose a plurality of grooves 8 having the same shape at equal intervals along the circumference of the suction surface 2. When the distance between adjacent grooves 8 varies depending on the position in the suction surface 2, the air flows differently between portions of large gap and small gap, thus resulting in higher tendency of air flow disturbance occurring near the circumference of the suction surface 2. When the grooves 8 have different shapes, velocity of the air flow FC varies among the grooves 8. As a result, a difference in quantity of air flowing into the grooves 8 from the side face of the cylindrical portion 5 of the vacuum suction nozzle 1 may occur among the grooves 8, thus resulting in higher tendency of air flow disturbance occurring in the vicinity of the circumference of the suction surface 2.

In the first vacuum suction nozzle 1 of the present invention, it is preferable that the suction surface 2 whereon the object is suctioned by vacuum is provided at the tip end, the portion having the suction surface 2 is formed from ceramics, the suction orifice 3 is formed on the suction surface 2, and the continuous surface 7 that changes smoothly from the side face of the cylindrical portion 5 near the suction surface 2 toward the suction surface 2 is formed over the entire circumference of the suction surface 2 as in the example shown in Fig. 4.

In the vacuum suction nozzle 1 of the second embodiment of the present invention, it is preferable that the suction surface 2 whereon the object is suctioned by vacuum is provided at the tip end, the portion having the suction surface 2 is formed from ceramics, the suction orifice 3 is formed on the suction surface 2, and a plurality of grooves 8 of the same shape that run from the side face of the cylindrical portion 5 toward the suction surface 2 are formed at equal intervals on the circumference of the suction surface 2 as in the example shown in Fig. 6 and Fig. 7.

The reason for forming the continuous surface 7 over the entire circumference of the suction surface 2, or forming the plurality of grooves 8 of the same shape at equal intervals on the circumference of the suction surface 2, is to suppress positional deviation of the object from occurring by canceling out the effects of disturbance of the air flows FB, FC generated at the confluence of the air flow FB and the air flow FC. When the continuous surface 7 is partially provided at a particular portion of the circumference of the suction surface 2, or dividedly provided, or the plurality of grooves 8 are partially provided at a particular position, there occurs a difference in intensity between the air flows FB, FC at the confluence of the air flow FB and the air flow FC on the suction surface 2, and the difference in intensity between the air flows FB, FC may cause positional deviation of the object.

In case that restriction by the configuration of the suction surface 2 on the arrangement of the grooves 8 allows it only to form three grooves 8 of such a shape as shown in Fig. 6 on the circumference of the suction surface 2, the three grooves 8 may be formed at three equally spaced positions along the circumference of the suction surface 2 so as to cancel out the synthesized force of the air flow FC, which makes it possible to more satisfactorily achieve the effect of suppressing positional deviation of the object, compared to a case of disposing the grooves 8 at unequal intervals.

When the continuous surface 7 is formed over the entire circumference of the suction surface 2, or the plurality of grooves 8 of the same shape are formed at equal intervals on the circumference of the suction surface 2, it becomes easier for air to flow over the entire suction surface 2 when the object is released by releasing the object. As a result, not only the object can be released without taking any time, but also the object can be released in a well-balanced manner by the existence of the continuous surface 7 or the plurality of grooves 8, thus effectively reducing the possibility of positional deviation and carry-back to occur.

The vacuum suction nozzle 1 of the present invention may have insulating or semi-conductive property. When the vacuum suction nozzle 1 has semi-conductive property, electrical resistance between the front end and rear end of the vacuum suction nozzle 1 may be set in a range from $10^3$ to $10^{11}$ $\Omega$, which makes it possible to prevent the vacuum suction nozzle 1 from being charged with static electricity generated through friction with air when the vacuum suction nozzle 1 moves at a high speed, and prevent the electronic component 15 from being moved or blown off by the repulsive force of static electricity. The vacuum suction nozzle 1 having the suction surface 2 as small as 0.7 mm or less in diameter is also capable of preventing such a trouble as a part of the suction surface 2 of the vacuum suction nozzle 1 hits and damages the electronic component that has been previously mounted and the surrounding components when mounting the object (electronic component 15) on the circuit board.

Moreover, use of ceramics in the vacuum suction nozzle 1 enables it to prevent the suction surface 2 from wearing prematurely through repetitive operations of picking up and releasing the electronic component 15. The ceramic material may be, for example, silicon carbide that has high wear resistance.

When electrical resistance between the front end and rear end of the vacuum suction nozzle 1 is in a range from $10^3$ to $10^{11}$ $\Omega$, even when the vacuum suction nozzle 1 is charged with static electricity, the static electricity can be discharged through the holding member 10 and the electronic component mounter 20. As a result, it is made possible to prevent static electricity from being suddenly discharged from the vacuum suction nozzle 1 and causing electrostatic breakdown of the surrounding components. Also because the static electricity is discharged from the vacuum suction nozzle 1, it is made possible to prevent the electronic component 15 from being moved or blown off by the repulsive force of static electricity even when the vacuum suction nozzle 1 comes near the electronic component 15. When electrical resistance is less than $10^3$ $\Omega$, static electricity of the surrounding components of the vacuum suction nozzle 1, if they are charged, tends to be discharged and cause electrostatic breakdown of the electronic component 15 that is suctioned thereon. When electrical resistance is more than $10^{11}$ $\Omega$, the vacuum suction nozzle 1 tends to be charged with static electricity and the electronic component 15 may be blown off by the repulsive force of static electricity when the vacuum suction nozzle 1 comes near the electronic component 15.

Fig. 8 is a front view showing a method for measuring the electrical resistance between the front end and rear end of the vacuum suction nozzle 1, depicting the electrode 60 put into contact with the suction surface 2 at the tip end of the vacuum suction nozzle 1, and the other electrode 60 put into contact with the end face of the head 6 at the rear end. The electrodes 60, 60 are connected to a resistance meter (not shown). The electrical resistance between the front end and rear end of the vacuum suction nozzle 1 can be measured by applying a voltage across the electrodes 60, 60 on the tip end and the rear end of the vacuum suction nozzle 1. The voltage applied for the measurement may be set in accordance with the shape and material of the vacuum suction nozzle 1 and the level of resistance, while about 10 to 1,500 V may be employed.

The suction surface 2 is preferably 0.7 mm or less in diameter. This is for the purpose of preventing such a problem from occurring as the suction surface 2 or the cylindrical portion 5 hit and break the electronic component that has been previously mounted and the surrounding components when the electronic component 15 having rectangular shape measuring 1 mm or less along the longer side is picked up and mounted on the circuit board having components mounted thereon in a high density. When the suction surface 2 is more than 0.7 mm, possibility of the suction surface 2 or the cylindrical portion 5 hitting and breaking the electronic component that has been previously mounted and the surrounding components becomes higher when the electronic component 15 having rectangular shape measuring 1 mm or less along the longer side is picked up and mounted on the circuit board having components mounted thereon in a high density. When the electronic component 15 is a chip component of type 0603 (measuring 0.6 mm by 0.3 mm), distance between adjacent components mounted on the circuit board may be as small as 0.1 mm, and therefore even a slight positional deviation of the electronic component 15 when suctioned onto the suction surface 2 may cause the suction surface 2 or the cylindrical portion 5 to hit and break the components disposed around the mounting position when the electronic component 15 is mounted.

While the suction surface 2 has ordinarily round shape, it may have any shape such as oval, rectangle, polygon or the like depending on the shape of the object. While the suction surface 2 has a non-circular shape, minimum size across the suction surface 2 may be set to 0.7 mm or less. This is because the suction surface 2 can be used by aligning the portion thereof having the minimum size across with the direction in which the electronic component 15 is mounted with the highest density. This is preferable because it enables manufacturing without decreasing the mechanical strength of the cylindrical portion 5.

In the example of the first embodiment, similarly to the vacuum suction nozzle 1 shown in Fig. 4, the suction surface 2 whereon the object is suctioned by vacuum and the suction orifice 3 are provided at the tip end of the cylindrical portion 5, and the continuous surface 7 is formed to be curved smoothly from the side face of the cylindrical portion 5 near the suction surface 2 toward the suction surface 2, or a plurality of grooves 8 are formed to run from the side face of the vacuum suction nozzle 1 toward the suction surface 2 as in the example shown in Fig. 6, so that the electronic component 15 can be reliably held without undergoing positional deviation due to slipping, and therefore the electronic component 15 can be carried and mounted on a circuit board without dropping. Also because there is the air flow passage between the crystal grains 22 of the second component in the suction surface 2 and the recesses 15a of the electronic component 15 in the state that the electronic component 15 is suctioned, the electronic component 15 does not stick to the suction surface 2, and the electronic component 15 can be released without taking any time when suction of air through the suction orifice 3 is stopped for releasing the electronic component 15 after mounting. Also the air flow is hardly disturbed significantly by the Venturi effect. As a result, posture of the object remains stable throughout the period from the time it is picked up from the tray to the time it is suctioned onto the suction surface 2, so that the object can be suctioned at the predetermined position of the suction surface 2, and positional deviation of the electronic component 15 can be suppressed from occurring when mounted.

It is also preferable that the ceramics used in the vacuum suction nozzle 1 of the present invention contains a conductivity imparting agent.

When the ceramics used in the vacuum suction nozzle 1 of the present invention contains a conductivity imparting agent, the vacuum suction nozzle 1 having a desired level of electrical conductivity can be made by adding the conductivity imparting agent to a ceramic material that is insulating by itself.

While alumina is an insulating ceramics, it is low-cost and has high wear resistance. Thus a material having a reasonable level of electrical conductivity can be made by adding titanium carbide or titanium nitride and the conductivity imparting agent to alumina. Thus using this material makes it possible to make the vacuum suction nozzle 1 that has high wear resistance and a reasonable level of electrical conductivity. Similarly, zirconia is a material having high strength, and acquires a reasonable level of electrical conductivity by adding the conductivity imparting agent such as iron oxide, titanium oxide or zinc oxide. Using this material makes it possible to make the vacuum suction nozzle 1 that is less likely to break even when formed to be a thin shape and that has the reasonable level of electrical conductivity. Use of silicon carbide ceramics enables it to make the vacuum suction nozzle 1 having a controlled value of electrical resistance by adding carbon.

The vacuum suction nozzle 1 of the present invention is preferably formed from black ceramics.

When vacuum suction nozzle 1 is formed from black ceramics, the electronic component 15 can be imaged with clear profile, as the image of the electronic component 15 is clearly captured due to the light from the light 17 reflected thereon against the dark background of the vacuum suction nozzle 1 formed from the black ceramics, when the electronic component 15 suctioned by the vacuum suction nozzle 1 is illuminated by the light 17 and captured by the CCD camera 18. Thus such an advantage is obtained as the image analyzing apparatus 19 can correctly recognize the shape of the electronic component 15 suctioned by the vacuum suction nozzle 1, so that positional accuracy is improved when mounting the electronic component 15 on the circuit board.

Examples of the black ceramics include zirconia, alumina and silicon carbide each containing a blackish conductivity imparting agent added therein. Also, ceramics having other color tones such as brownish or bluish color tone can exert the same effect as that of black ceramics by imparting a dark color tone.

Examples of the conductivity imparting agent, that can be used as ceramics having a dark color tone by adding to alumina ceramics even if it has a brownish or bluish color tone, include iron oxide, nickel oxide, titanium carbide and titanium nitride. Among these conductivity imparting agents, iron oxide and titanium carbide are preferably used as the conductivity imparting agent that enables the production of black ceramics. Examples of the conductivity imparting agent, that can be used as ceramics having a dark color tone by adding to zirconia ceramics even if it has a blackish, brownish or bluish color tone, include iron oxide, titanium oxide, cobalt oxide, chromium oxide and nickel oxide. Among these conductivity imparting agents, iron oxide is preferably used as the conductivity imparting agent that enables the production of black ceramics. Silicon carbide ceramics having electrical conductivity imparted by adding carbon are preferably used as black ceramics.

Furthermore, ceramics used for the vacuum suction nozzle 1 of the present invention are preferably zirconia ceramics containing a stabilizing agent.

It is preferable to use zirconia ceramics containing a stabilizing agent for the vacuum suction nozzle 1 because this kind of ceramics has high mechanical strength. Particularly in the case of vacuum suction nozzle 1 having the cylindrical portion 5 of small diameter as the vacuum suction nozzle 1 shown in Fig. 1(a), when the electronic component 15 suctioned onto the suction surface 2 is mounted on a circuit board, an adjacent component and the tip end of the vacuum suction nozzle 1 may collide and damage the cylindrical portion 5. Therefore, it is preferable to use zirconia that has high strength.

The stabilizing agent added to the zirconia ceramics may be yttria, ceria, magnesia or the like. Zirconia having sufficiently high strength for practical use can be obtained by containing 2 to 8 mol% of such a stabilizing agent. The mean crystal grain size of zirconia is preferably 3 μm or less. In case zirconia having a mean crystal grain size of 3 μm or less is used, crystal grains become less likely to come off and therefore the suction surface 2 is less likely to chip off, when the suction surface 2 is ground for mirror-finish polishing during manufacture or repair of the vacuum suction nozzle 1.

It is also preferable that the vacuum suction nozzle 1 of the present invention is formed from zirconia ceramics containing a stabilizing agent wherein at least one of iron oxide, cobalt oxide, chromium oxide and nickel oxide is contained as the conductivity imparting agent. The conductivity imparting agent can not only render electrical conductivity to the zirconia ceramics but also give a color to the ceramics such as blackish color with iron oxide, bluish color with cobalt oxide, and greenish color with chromium oxide.

When the electronic component 15 is suctioned thereon by the vacuum suction nozzle 1, the light 17 directs light to the electronic component 15 suctioned thereon by the vacuum suction nozzle 1, and the CCD camera 18 receives the reflected light, while dark color tone can be selected for the vacuum suction nozzle 1 against the color tone of the electronic components 15. As a result, the vacuum suction nozzle 1 and the electronic component 15 can be rendered with color tones that are easily distinguished by the image analyzing apparatus 19, so that recognition error and malfunction can be reduced.

In general, the electronic component 15 usually has white, silver or grey color, and therefore the vacuum suction nozzle 1 is often required to have dark color tone such as black. In order to make the vacuum suction nozzle 1 having dark color tone, it is preferable to use zirconia ceramics containing for example, 65% by mass of zirconia, 30% by mass of iron oxide, 3% by mass of cobalt oxide and 2% by mass of chromium oxide. When the electronic component 15 has silver color, it is preferable that the vacuum suction nozzle 1 has dark blackish color which can be obtained by containing 25% by mass or more iron oxide.

A method for manufacturing vacuum suction nozzle 1 made of ceramics of the present invention will be described below.

It is possible to use, as ceramics that constitute the vacuum suction nozzle 1 of the present invention, known materials such as silicon carbide, alumina, and zirconia containing a stabilizing agent.

For example, a material obtained by mixing 95% by mass of silicon carbide with 5% by mass of aluminum as a sintering aid is charged into a ball mill and crushed to a predetermined grain size to prepare a slurry, which is then spray-dried using a spray dryer to form granular materials.

Next, granular materials and a thermoplastic resin are charged into a kneader, and kneaded while heating to obtain a green body, which is then charged into a pelletizer to obtain pellets that would be turned into a material for injection molding. As the thermoplastic resin to be charged into the kneader, an ethylene-vinyl acetate copolymer, polystyrene or an acrylic resin may be added in the proportion of about 10 to 25% by mass based on the mass of granular materials, and the heating temperature during kneading using the kneader may be set within a range from 140 to 180°C. The kneading conditions may be appropriately set according to the kind or grain size of ceramics, and the kind of the thermoplastic resin.

The pellets obtained as described above are charged into an injection molding machine and subjected to injection molding operation, to obtain a green compact that would be turned into the vacuum suction nozzle 1 by sintering it. As the green compact has a runner formed from excessive material that has solidified during injection the molding process, the runner is cut off before degreasing.

Silicon carbide may be sintered under such firing conditions, for example, in a vacuum atmosphere or in an atmosphere of an inert gas such as argon or helium, and the maximum temperature is set within a range from 1,900 to 2,200°C, and the retention time at the maximum temperature may be set within a range from 1 to 5 hours.

Furthermore, when zirconia ceramics and alumina ceramics each containing a stabilizing agent are used as ceramics that constitute the vacuum suction nozzle 1 of the present invention, it is possible to use, as the conductivity imparting agent, at least one kind of iron oxide, cobalt oxide, chromium oxide and nickel oxide, or those containing titanium carbide or titanium nitride.

For example, 65% by mass of zirconia containing yttria as a stabilizing agent is mixed with 35% by mass of iron oxide and the obtained material is charged into a ball mill and then crushed to a predetermined grain size to prepare a slurry. Using a spray dryer, the slurry is spray-dried to form granular materials, which are then charged into an injection molding machine, injection-molded in the same manner as described above and sintered to obtain a green compact that would be turned into a vacuum suction nozzle 1.

The shape of the vacuum suction nozzle 1 of the present invention can be formed by making a die having the shape of the vacuum suction nozzle 1 by the ordinary injection molding process, and setting the die in the injection molding machine. Thus the green compact of the vacuum suction nozzle 1 having the desired shape can be easily made.

Sintering conditions for zirconia ceramics and alumina ceramics are as follows. When at least one of iron oxide, cobalt oxide, chromium oxide and nickel oxide is contained as the conductivity imparting agent, the material may be sintered with maximum temperature set in a range from 1,300 to 1,500°C, while keeping the maximum temperature for a period of 1 to 5 hours in air atmosphere. When titanium carbide is used as the conductivity imparting agent, the material may be sintered with maximum temperature set in a range from 1,400 to 1,800°C, while keeping the maximum temperature for a period of 1 to 5 hours in vacuum or inactive gas atmosphere such as argon. When titanium nitride is used as the conductivity imparting agent, the material may be sintered in nitrogen atmosphere, in addition to vacuum or inactive gas atmosphere. Thus a reasonable level of electrical conductivity can be given to the vacuum suction nozzle 1 formed from ceramics.

The vacuum suction nozzle 1 that has been sintered may be polished on the surface by a barrel polisher or the like to make the surface condition of the ceramics uniform, so that electrical conductivity on the surface of the ceramics would not become lower than that of the inside, or vary and become unstable.

In order to form the continuous surface 7 by a method other than the injection molding process, such a process may be employed as a green compact having the shape of the vacuum suction nozzle 1 is made in advance, and mirror-finish machining is applied to the suction surface 2 provided at the tip end of the cylindrical portion 5 so that the suction surface 2 becomes perpendicular to the longitudinal direction of the vacuum suction nozzle 1, followed by barrel polishing or shot blast process to form the continuous surface 7 on the circumference of the suction surface 2, or lathing operation on the circumference of the suction surface 2 to form the continuous surface 7.

In order to form the plurality of grooves 8 by a method other than the injection molding process, such a process may be employed as the suction surface 2 is machined so as to become perpendicular to the longitudinal direction of the vacuum suction nozzle 1, similarly to the method described above, followed by ultrasonic machining or electrodischarge machining to form the plurality of grooves 8.

Examples

(Example 1)

Examples of the present invention will be described below.

Using stabilized zirconia containing 3 mol% of yttria as the main component and alumina as the second component, specimens Nos. 1 to 11 were made. First, zirconia and alumina were charged into separate ball mills together with a solvent and then crushed to a predetermined grain size to prepare slurries. The obtained slurries are mixed and then spray-dried using a spray dryer to prepare granular materials. The mixing ratio of zirconia to alumina was set so that the proportion of zirconia becomes 90% by mass and the proportion of alumina becomes 10% by mass.

The obtained granular materials, and an ethylene-vinyl acetate copolymer, polystyrene and an acrylic resin as thermoplastic resins were charged into a kneader. The ethylene-vinyl acetate copolymer, polystyrene and acrylic resin were charged in the total proportion of 20% by mass based on 100% by mass of the granular materials. The mixture was kneaded while maintaining at the temperature of about 150°C to prepare a green body. Then, the obtained green body was charged into a pelletizer to prepare pellets that are used as materials for injection molding. The obtained pellets were charged into a known injection molding machine to prepare a green compact that would be turned into a vacuum suction nozzle as an example shown in Fig. 1.

The green compact thus obtained was put into a dryer to dry, and was sintered with maximum temperature set in a range from 1,400 to 1,500°C while keeping the maximum temperature for a period of 1 to 5 hours in air atmosphere, to make a sintered body. The sintered body was subjected to barrel polishing operation to remove the surface ceramics to a depth of several micrometers to form mirror surface in the portion of the vacuum suction nozzle that would become the suction surface. Chemical etching and ion milling were applied to the suction surface to cause the second component to protrude, thereby to obtain specimens Nos. 1 to 11 of the vacuum suction nozzle having cylindrical portion 5 measuring 3.2 mm in length and 0.30 mm in wall thickness and measuring 0.8 mm in outer diameter and 0.2 mm in inner diameter.

The mean crystal grain size of zirconia was calculated with the formulas (1) and (2) by applying the planimetric method to a photograph of the surface of the vacuum suction nozzle taken with an ordinary scanning electron microscope (SEM).

(Planimetric Method)

A circle having a predetermined inner area (A) was drawn on the SEM photograph, and the number of grains NG per unit area was determined by formula (1) from the number of grains nc within the circle and the number of grains ni lying on the circle. Since 1/NG is the area occupied by one grain, mean crystal grain size was determined by formula (2). The constant m is the factor of magnification of the SEM photograph.

$$NG = (nc + ni/2)/(A/m^2) \qquad (1)$$

$$D = 2/\sqrt{(\pi NG)} \qquad (2)$$

The mean crystal grain size of alumina was determined by measuring the major diameter and minor diameter of alumina crystal grains on an SEM photograph of the suction surface that had been mirror-finished, and calculating with formula (3).

$$\{\Sigma(\text{Major diameter} + \text{Minor diameter})/2\}/\text{Number of alumina}$$

$$\text{crystal grains} \qquad (3)$$

Protruding height of alumina crystal grains as the second component was determined by measuring the difference between the apex of the alumina crystal grain and the apex of zirconia crystal grain that adjoins the alumina crystal grain at five points on an SEM photograph of the suction surface, and averaging the measurements.

Then the specimens Nos. 1 to 11 of the vacuum suction nozzle were installed on the electronic component mounter 14 of the example shown in Fig. 2, and subjected to a test of mounting ten million electronic components 15 of type 0603 (measuring 0.6 mm by 0.3 mm) on a dummy circuit board. This test was conducted to check the occurrence of such troubles as positional deviation of the electronic component 15 and carry-back in which the electronic component 15 was carried to the mounting position but was unable to release for mounting. Positional deviation refers to a case where the position determined by the image analyzing apparatus 19 on the image captured by the CCD camera 18 requires correction.

A specimen that caused no positional deviation of the electronic component or carry-back was rated as "A", one that caused one to three incidents of the trouble was rated as "B", and one that caused four or more incidents of the trouble was rated as "C", since this is comparable to or worse than the prior art. Whether the suction surface was chipped off or not after the test was evaluated and specimen that caused no chipping was rated as "A", one that caused chipping smaller than 0.2 mm was rated as "B", and one that caused chipping 0.2 mm or more was rated as "C". The results are shown in Table 1.

[Table 1]

| Specimen No. | Mean crystal grain size ofzirconia ($\mu$m) | Mean crystal grain size of alumina ($\mu$m) | Protruding height of alumina ($\mu$m) | Positional deviation | Carry-back | Chipping of suction surface |
|---|---|---|---|---|---|---|
| 1 | 0.4 | 1.0 | 0.5 | B | A | A |
| 2 | 0.6 | 1.0 | 0.5 | B | A | A |
| 3 | 0.8 | 1.0 | 0.5 | B | A | A |
| *4 | 1.0 | 1.0 | 0.5 | C | A | A |
| *5 | 1.2 | 0.8 | ≤0.3 | C | A | A |

(continued)

| Specimen No. | Mean crystal grain size ofzirconia (μm) | Mean crystal grain size of alumina (μm) | Protruding height of alumina (μm) | Positional deviation | Carry-back | Chipping of suction surface |
|---|---|---|---|---|---|---|
| 6 | 0.5 | 2.5 | 0.5 | B | A | A |
| 7 | 0.5 | 2.5 | 0.8 | B | A | A |
| 8 | 0.5 | 2.5 | 1.0 | A | A | A |
| 9 | 0.5 | 12.0 | 5.0 | A | A | A |
| 10 | 0.5 | 22.0 | 7.0 | A | A | A |
| 11 | 0.5 | 22.0 | 9.0 | A | B | B |

Specimen marked with * is out of the scope of the present invention.

From the results shown in Table 1, it can be seen that four or more incidents of positional deviation of the electronic component occurred with specimen No. 4 where the mean crystal grain size of the main component and the mean crystal grain size of the second component were the same, and specimen No. 5 where the mean crystal grain size of the main component was larger than the mean crystal grain size of the second component, both specimens being out of the scope of the present invention. With specimens Nos. 1 to 3 and 6 to 11 made as example of the present invention, in contrast, since the ceramics contains the second component that has a mean crystal grain size larger than the mean crystal grain size of the main component, and the crystal grains of the second component protrude more than the crystal grains of the main component on the suction surface, the crystal grains of the second component protruding from the suction surface and the recesses existing in the surface of the electronic component 15 loosely lock with each other when the electronic component 15 is suctioned. As a result, the electronic component 15 could be held surely without undergoing positional deviation due to slipping, and therefore positional deviation of the electronic component occurring with three or less pieces among ten million pieces.

With regard to carry-back with specimens Nos. 1 to 3 and 6 to 10 which were made as example of the vacuum suction nozzle of the present invention, the electronic component 15 did not stick to the suction surface and no incident of carry-back occurred, since the crystal grains of the second component protruded more than the crystal grains of the main component on the suction surface and there was the air flow on the suction surface so that air could flow between the suction surface and the electronic component 15.

One to three electronic components were carried back with specimen No. 11 that was example of the vacuum suction nozzle of the present invention. While what caused this is not clear, it might be because protruding height of the crystal grains of the second component was 9 μm and the crystal grains of the second component meshed with the recesses existing in the surface of the electronic component 15. The cause of chipping measuring 0.2 mm or less occurring in the suction surface of specimen No. 11 is supposedly that mean crystal grain size of the second component was large and protruding height was as large as 9 μm, that caused the crystal grains to come off.

From these results of evaluation of positional deviation, carry-back and chipping of the suction surface, it was found that the suction surface formed from ceramics containing the second component that has a mean crystal grain size larger than the mean crystal grain size of the main component whereon the crystal grains of the second component protrude by 1 to 7 μm more than the crystal grains of the main component is suited for the suction surface of the vacuum suction nozzle of the electronic component mounter.

(Example 2)

Specimens Nos. 12 to 21 of the vacuum suction nozzle containing zirconia as the main component and alumina as the second component were made in the same manner as in Example 1. In addition, green compacts of the vacuum suction nozzle containing alumina as the main component and titanium carbide as the second component were made in the same manner as in Example 1, and were dried in a vacuum dryer. Then sintered bodies were made by sintering with maximum temperature set in a range from 1,500 to 1,650°C in vacuum, while keeping the maximum temperature for a period of 1 to 5 hours. The sintered bodies were machined similarly to Example 1, thereby making specimens Nos. 22 and 23 of the vacuum suction nozzle. Specimens Nos. 22 and 23 had composition of 90% by mass of alumina and 10% by mass of titanium carbide.

Mean crystal grain size and protruding height of the second component were measured in the same manner as in Example 1. Then specimens Nos. 12 to 23 of the vacuum suction nozzle were installed on the electronic component mounter 14 shown in Fig. 2, and tested similarly to Example 1, to evaluate positional deviation, carry-back and chipping of the suction surface. Method of evaluation was the same as in Example 1. The results are shown in Table 2.

[Table 2]

| Specimen No. | Composition of main component | Mean crystal grain size of main component (μm) | Second component | | Protruding height of second component (μm) | Positional deviation | Carry-back | Chipping of suction surface |
| --- | --- | --- | --- | --- | --- | --- | --- | --- |
| | | | Mean crystal grain size of alumina (μm) | Mean crystal grain size of titanium carbide (μm) | | | | |
| 12 | Zirconia | 0.2 | 2.5 | - | 1.0 | A | A | B |
| 13 | Zirconia | 0.3 | 2.5 | - | 1.0 | A | A | A |
| 14 | Zirconia | 0.5 | 2.5 | - | 1.0 | A | A | A |
| 15 | Zirconia | 0.8 | 2.5 | - | 1.0 | A | A | A |
| 16 | Zirconia | 1.0 | 2.5 | - | 1.0 | A | A | A |
| 17 | Zirconia | 0.2 | 1.0 | - | 0.5 | B | A | B |
| 18 | Zirconia | 0.3 | 1.0 | - | 0.5 | B | A | A |
| 19 | Zirconia | 0.5 | 1.0 | - | 0.5 | B | A | A |
| 20 | Zirconia | 0.8 | 1.0 | - | 0.5 | B | A | A |
| *21 | Zirconia | 1.0 | 1.0 | - | ≤0.3 | C | A | A |
| 22 | Alumina | 1.0 | - | 2.5 | 1.0 | A | A | B |
| 23 | Alumina | 1.8 | - | 2.5 | 1.0 | A | A | B |
| Specimen marked with * is out of the scope of the present invention. | | | | | | | | |

From the results shown in Table 2, it was found that specimen No. 21 that was out of the scope of the present invention experienced positional deviation and was evaluated as "C", because the mean crystal grain size of the main component and the mean crystal grain size of the second component were the same, and protruding height of the second component on the suction surface was low. In specimens Nos. 12 to 20, 22 and 23 which were made as example of the vacuum suction nozzle of the present invention, in contrast, since the ceramics contained the second component that had mean crystal grain size larger than the mean crystal grain size of the main component, and the crystal grains of the second component protruded more than the crystal grains of the main component on the suction surface, the protruding crystal grains of the second component and the recesses existing in the surface of the electronic component 15 loosely lock with each other when the electronic component 15 was suctioned thereon. As a result, the electronic component 15 could be held surely without undergoing positional deviation due to slipping. Thus positional deviation of the electronic component 15 occurred with three or less pieces among ten million pieces.

In specimens Nos. 12 to 20, 22 and 23 which were made as example of the vacuum suction nozzle of the present invention, the electronic component 15 did not stick to the suction surface and no incident of carry-back occurred, since the crystal grains of the second component protruded more than the crystal grains of the main component on the suction surface and there was the air flow passage between the suction surface 2 and the electronic component 15.

With regard to chipping of the suction surface, specimens Nos. 12 to 20, 22 and 23 which were made as example of the vacuum suction nozzle of the present invention were rated as "B" or "A". The difference in rating between specimens Nos. 12 to 20 and specimens Nos. 22 and 23 was supposedly caused by the difference in strength between the main component of zirconia and alumina. The difference in rating among specimens Nos. 12 to 20 that contained zirconia as the main component was supposedly caused by the difference in strength between mean crystal grain size of zirconia in specimens Nos. 12 and 17 was 0.2 μm, and mean crystal grain size of alumina was not sufficient relative to this mean crystal grain size, thus failing to achieve sufficient strength.

From these results of evaluation of positional deviation, carry-back and chipping of the suction surface, it was found that the suction surface formed from ceramics containing the second component that has a mean crystal grain size larger than the mean crystal grain size of the main component whereon the crystal grains of the second component protrude more than the crystal grains of the main component is suited for the suction surface of the vacuum suction nozzle of the electronic component mounter. It was also found that zirconia that has higher strength is more suited as the main component than alumina, and practically sufficient strength can be obtained by using zirconia of mean crystal grain size in a range from 0.3 to 1 $\mu$m.

(Example 3)

Vacuum suction nozzle formed from stabilized zirconia containing 3 mol% of yttria as the main component and the second component was made. Zirconia containing of the main component and zirconia of the second component were charged into separate ball mills together with a solvent and then crushed so that mean crystal grain size after sintering would become 0.5 $\mu$m for zirconia of the main component and mean crystal grain size after sintering would be in a range from 1.5 to 2.5 $\mu$m for zirconia of the second component. These slurries thus obtained were spray-dried separately to prepare granular materials.

The granular material of the zirconia of the main component was used to form the green compact of the vacuum suction nozzle in the same manner as in Example 1 and, with the granular material of the zirconia of the second component deposited on the suction surface of the green compact, sintered under the same conditions as in Example 1 to make sintered body. The sintered body was subjected to barrel polishing operation to remove the surface ceramics to a depth of several micrometers, and lapping operation was applied to the suction surface so that protruding height of the crystal grains of the second component, zirconia, would become the value shown in Table 3, thereby to obtain specimens Nos. 24 and 25 of the vacuum suction nozzle.

The mean crystal grain size and protruding height of the crystal grains of the second component were measured by in the same manner as in Example 1. Then specimens Nos. 24 and 25 of the vacuum suction nozzle were installed on the electronic component mounter 14 shown in Fig. 2, and tested similarly to Example 1, to evaluate positional deviation, carry-back and chipping of the suction surface. Method of evaluation was the same as in Example 1. The results are shown in Table 3. Table 3 also includes the results of specimen No. 14 for comparison.

[Table 3]

| Specimen No. | Composition of main component | Mean crystal grain size of main component (μm) | Composition of second component | Mean crystal grain size of second component (μm) | Protruding height of second component (μm) | Positional deviation | Carry-back | Chipping of suction surface |
|---|---|---|---|---|---|---|---|---|
| 24 | Zirconia | 0.5 | Zirconia | 1.5 | 0.5 | B | A | A |
| 25 | Zirconia | 0.5 | Zirconia | 2.5 | 1.0 | B | A | A |
| 14 | Zirconia | 0.5 | Alumina | 2.5 | 1.0 | A | A | A |

From the results shown in Table 3, it can be seen that no carry-back occurred and the suction surface was not chipped with specimens Nos. 24 and 25 of the vacuum suction nozzle that were made as example of the present invention. Positional deviation occurred in three pieces among ten million pieces with specimen No. 24, and in two pieces among ten million pieces with specimen No. 25. It is supposed that these results reflect the difference in protruding height of the second component. Comparison of specimen No. 25 and specimen No. 14, that had the same mean crystal grain size of the main component, the same mean crystal grain size of the second component and the same protruding height of the second component, but contained different materials as the second component, showed that specimen No. 14 was capable of maintaining the state of the crystal grains of the second component and the recesses existing in the surface of the electronic component 15 loosely lock with each other over a longer period of time. This is supposedly because alumina has higher hardness than zirconia and is resistant to wear.

(Example 4)

In the same manner as in Example 1 in which a green compact is obtained using 50 to 90% by mass of stabilized zirconia containing 3 mol% of yttria as the main component and 10 to 50% by mass of any one kind of iron oxide, zinc oxide, titanium carbide and titanium nitride as the second component, a green compact for a vacuum suction nozzle was obtained. The green compact for a vacuum suction nozzle obtained using iron oxide or zinc oxide as the second component was dried by placing in a dryer and then firmed in air atmosphere at a maximum temperature set within a range from 1,300 to 1,500°C for a retention time at the maximum temperature set within a range from 1 to 5 hours to obtain a sintered body. The green compact for a vacuum suction nozzle obtained using titanium carbide or titanium nitride as the second component was dried by placing in a dryer and then firmed in air atmosphere at a maximum temperature set within a range from 1,400 to 1,650°C for a retention time at the maximum temperature set within a range from 1 to 5 hours to obtain a sintered body. The obtained sintered body was formed in the same manner as in Example 1 to obtain vacuum suction nozzles as specimens Nos. 26 to 45.

The mean crystal grain size and protruding height of the second component were measured in the same manner as in Example 1. Electrical resistance between the front end and rear end of the vacuum suction nozzle 1 were measured by the method shown in Fig. 8. Then specimens Nos. 26 to 45 of the vacuum suction nozzle were installed on the electronic component mounter 14 shown in Fig. 2, and tested for blow-off of the electronic component 15 and electrostatic breakdown of the electronic component 15.

If the vacuum suction nozzle is charged with static electricity generated through friction with air when the vacuum suction nozzle 1 moves at a high speed, the electronic component 15 would be blown off by the repulsive force of static electricity when the electronic component 15 is suctioned thereon, thus failing to suction. Blow-off of the electronic component 15 was checked by operating the electronic component mounter 14 to suction ten million pieces and counting the number of electronic components 15 mounted on a dummy circuit board, thereby counting the incidents of blow-off of the electronic component 15. Distance between adjacent electronic components 15 before mounting was evaluated as 0.1 mm at the minimum. The result is indicated with "A" when three or less pieces were blown off, "B" when four to ten pieces were blown off, and "C" when 11 or more pieces were blown off.

Electrostatic breakdown of the electronic component 15 was checked as follows. The electronic component mounter 14 was operated to suction ten million pieces and mounting the 100 electronic components 15 per one dummy circuit board where circuit had been formed, and continuity test was conducted for each dummy circuit board by using a commonly used circuit continuity tester. On a dummy circuit board which did not show continuity, the continuity of the individual electronic components 15 mounted thereon was tested and the number of electronic components 15 failing due to electrostatic breakdown was counted. The result is indicated with "A" when three or less pieces suffered electrostatic breakdown, "B" when four to ten pieces suffered electrostatic breakdown, and "C" when 11 or more pieces suffered electrostatic breakdown.

[Table 4]

| Specimen No. | Main component | Second component | | | | | Electrical resistance between front end and rear end (Ω) | Blow-off of the electronic component | Electrostatic breakdown of electronic component |
|---|---|---|---|---|---|---|---|---|---|
| | Mean crystal grain size of zirconia (μm) | Mean crystal grain size of iron oxide (μm) | Mean crystal grain size of zinc oxide (μm) | Mean crystal grain size of titanium carbide (μm) | Mean crystal grain size of titanium nitride (μm) | Protruding height (μm) | | | |
| 26 | 0.4 | 4.5 | - | - | - | 2.2 | $10^3$ | A | C |
| 27 | 0.4 | 4.5 | - | - | - | 2.2 | $10^4$ | A | B |
| 28 | 0.4 | 4.5 | - | - | - | 2.2 | $10^5$ | A | A |
| 29 | 0.4 | 4.5 | - | - | - | 2.2 | $10^9$ | A | A |
| 30 | 0.4 | 4.5 | - | - | - | 2.2 | $10^{10}$ | C | A |
| 31 | 0.4 | - | 4.7 | - | - | 1.5 | $10^3$ | A | C |
| 32 | 0.4 | - | 4.7 | - | - | 1.5 | $10^4$ | A | B |
| 33 | 0.4 | - | 4.7 | - | - | 1.5 | $10^5$ | A | A |
| 34 | 0.4 | - | 4.7 | - | - | 1.5 | $10^9$ | A | A |
| 35 | 0.4 | - | 4.7 | - | - | 1.5 | $10^{10}$ | C | A |
| 36 | 0.7 | - | - | 2.6 | - | 1.1 | $10^3$ | A | C |
| 37 | 0.7 | - | - | 2.6 | - | 1.1 | $10^4$ | A | B |
| 38 | 0.7 | - | - | 2.6 | - | 1.1 | $10^5$ | A | A |
| 39 | 0.7 | - | - | 2.6 | - | 1.1 | $10^9$ | A | A |
| 40 | 0.7 | - | - | 2.6 | - | 1.1 | $10^{10}$ | C | A |
| 41 | 0.7 | - | - | - | 2.2 | 1.0 | $10^3$ | A | C |
| 42 | 0.7 | - | - | - | 2.2 | 1.0 | $10^4$ | A | B |
| 43 | 0.7 | - | - | - | 2.2 | 1.0 | $10^5$ | A | A |
| 44 | 0.7 | - | - | - | 2.2 | 1.0 | $10^8$ | A | A |
| 45 | 0.7 | - | - | - | 2.2 | 1.0 | $10^{10}$ | C | A |

From the results shown in Table 4, it can be seen that blow-off of the electronic component 15 occurred in three or less pieces per ten million pieces with specimens Nos. 26 to 29, 31 to 34, 36 to 39 and 41 to 44 (example of vacuum suction nozzle of the present invention) that had electrical resistance between the front end and rear end of the vacuum suction nozzle in a range from $10^3$ to $10^9$ Ω. This result shows that static electricity generated through friction with air when the vacuum suction nozzle 1 moves at a high speed to repeat suctioning and mounting operations can be reliably discharged while preventing the vacuum suction nozzle 1 from being charged with the static electricity.

Electrostatic breakdown of the electronic component 15 occurred in three or less pieces among ten million pieces with specimens Nos. 28 to 30, 33 to 35, 38 to 40 and 43 to 45 as Examples of the vacuum suction nozzle of the present invention. Electrostatic breakdown occurs as the vacuum suction nozzle is charged with static electricity generated through friction with air when the vacuum suction nozzle moves at a high speed, and electric discharge occurs when the electronic component 15 is suctioned. In example of the vacuum suction nozzle of the present invention, it was found that possibility of electrostatic breakdown can be decreased by setting the electrical resistance between the front end and rear end of the vacuum suction nozzle in a range from $10^5$ to $10^{10}$ Ω.

Thus the results of checking the blow-off of the electronic component 15 and electrostatic breakdown of the electronic component 15 show that the electrical resistance between the front end and rear end of the vacuum suction nozzle is preferably in a range from $10^5$ to $10^{10}$ Ω.

(Example 5)

First, zirconia containing 3 mol% of yttria as a stabilizing agent was selected as ceramics and then a coloring agent, that is used for enhancing visibility of a camera by blackening, such as iron oxide, cobalt oxide, chromium oxide or nickel oxide was added in the total proportion of 10% by mass based on 100% by mass of zirconia. To the obtained material, water was added, followed by crushing and mixing using a ball mill to prepare a slurry, and the obtained slurry was spray-dried using a spray dryer to prepare each granular material.

To 100% by mass of the granular materials, an ethylene-vinyl acetate copolymer, polystyrene and an acrylic resin were added in the total proportion of 20% by mass and the mixture was charged into a kneader, and then kneaded while maintaining at the temperature of about 150°C to prepare a green body. The obtained green body was charged into a pelletizer to prepare pellets that would be turn into a material for injection molding. The pellets were charged into a known injection molding machine to obtain green compact that wound be turn into a nozzle 1 for vacuum suction shown in Fig. 1.

The green compact was put into a dryer to dry, and was sintered with maximum temperature set in a range from 1,400 to 1,500°C while keeping the maximum temperature for a period of 1 to 5 hours in air atmosphere, to make a sintered body. The sintered body was subjected to barrel polishing operation to remove the surface ceramics to a depth of several micrometers to form mirror surface in the portion of the vacuum suction nozzle 1 that would become the suction surface 2. The smooth continuous surface 7 shown in Fig. 4 was formed on the suction surface 2, while radius d of the suction orifice 3, radius e of the suction surface 2, radius f of the cylindrical portion 5 and radius r of the continuous surface 7 in section taken along lines A-A' were set as shown in Table 5. These specimens are referred to as Nos. 101 to 110.

Radius d of the suction orifice 3, radius e of the suction surface 2, and radius f of the cylindrical portion 5 were measured by using an ordinary tool microscope.

Then the specimens Nos. 101 to 110 of the vacuum suction nozzle were installed on the electronic component mounter 14, and subjected to vacuum suction test of the electronic component 15 of type 0603 (measuring 0.6 mm by 0.3 mm) to check positional deviation of the electronic component 15.

The electronic component mounter 14 was operated to suction ten million pieces and mount the electronic component 15 on a dummy circuit board, and the number of incidents positional deviation of the electronic component 15 was counted. In Table 5, the result is indicated with "A" when no positional deviation occurred, "B" when positional deviation occurred in one to three pieces, and "C" when positional deviation occurred in four or more pieces since this is comparable to or worse than the prior art.
The results are shown in Table 5.

Table 5

| Specimen No. | Shape of continuous surface | | | | Positional deviation | Damage on suction surface |
|---|---|---|---|---|---|---|
| | Radius e of suction orifice (mm) | Radius f of suction surface (mm) | Radius g of cylindrical portion (mm) | Radius r of continuous surface (mm) | | |
| 101 | 0.15 | 0.17 | 0.4 | 0.23 | B | C |
| 102 | 0.15 | 0.18 | 0.4 | 0.22 | A | B |
| 103 | 0.15 | 0.25 | 0.4 | 0.15 | A | B |
| 104 | 0.15 | 0.3 | 0.4 | 0.1 | A | B |
| 105 | 0.15 | 0.33 | 0.4 | 0.07 | A | B |
| 106 | 0.15 | 0.36 | 0.4 | 0.04 | B | B |
| *107 | 0.15 | 0.4 | 0.4 | 0 | C | B |
| *108 | 0.15 | 0.75 | 0.75 | 0 | C | B |
| Specimen marked with * is out of the scope of the present invention. | | | | | | |

The results shown in Table 5 show that positional deviation of the electronic component and damage occurred in three pieces or less among ten million pieces with specimens Nos. 101 to 106 made as example of the vacuum suction nozzle of the present invention. In specimens Nos. 107 and 108 made as Comparative Example, in contrast, four or more pieces experienced positional deviation or damage. Thus it is found that specimens of example of the vacuum suction nozzle of the present invention surpass these specimens. Specifically, specimens Nos. 101 to 106 made as Example of the present invention had the continuous surface 7 that changed smoothly from the side face of the cylindrical portion 5 of the vacuum suction nozzle 1 toward the suction surface 2 provided at the tip end, and was therefore capable of reliably holding the object (electronic component 15) without positional deviation. Particularly with specimens Nos. 102 to 105 made as Example of the present invention, positional deviation of the object did not occur and the suction surface 2 was not damaged, and therefore it is supposed that radius d of the suction orifice 3, radius e of the suction surface 2 and radius f of the cylindrical portion 5 were well-balanced so that air flow was less likely to be disturbed near the circumference of the suction surface 2.

With specimen No. 101 made as Example of the present invention, while positional deviation occurred in one to three pieces, a minor damage occurred in the suction surface 2. Since air flow may be disturbed near the circumference of the suction surface as this damage increases, thereby increasing the possibility of positional deviation of the object, it is preferable to set the radius e of the suction surface 2 to 1.2 times or more the radius d of the suction orifice 3. With specimen No. 106 made as Example of the present invention, positional deviation occurred in one to three pieces and no damage occurred in the suction surface 2. However, it is supposed that since the area of the smooth continuous surface 7 was small, air flow near the circumference of the suction surface was not stabilized, thus resulting in positional deviation of the object. Therefore, in order to maintain the area of the continuous surface 7 and stabilize the air flow, it is preferable to set the radius f of the cylindrical portion 5 to 1.2 times or more the radius e of the suction surface 2.

In specimens Nos. 107 and 108 made as Comparative Example of the present invention, in contrast, it is supposed that four or more pieces experienced positional deviation because the radius e of the suction surface 2 and the radius f of the cylindrical portion 5 were the same thus making it impossible to form the continuous surface 7.

(Example 6)

The vacuum suction nozzle 1 was made in the same manner as in Example 5, and six grooves 8 of the shape shown in Fig. 6 were formed so that six grooves 8 divide the circumference of the suction surface 2 into six equal portions. The width H and the depth I of the groove 8 were set as shown in Table 2. The cylindrical portion 5 of the vacuum suction nozzle 1 was formed in sizes of 3.2 mm in length and 0.35 mm in wall thickness and measuring 1 mm in outer diameter and 0.3 mm in inner diameter, with the groove 8 having a length J of 1 mm. These specimens are referred to as Nos. 109 to 115.

The width H and the depth I of the groove 8 were measured by using an ordinary tool microscope.

Then these specimens of the second vacuum suction nozzle 1 were installed on the electronic component mounter 14, and subjected to vacuum suction test of the electronic component 15 of type 0603 (measuring 0.6 mm by 0.3 mm) to check positional deviation of the electronic component 15.

Positional deviation of the electronic component 15 was checked by operating the electronic component mounter 14 to suction ten million pieces and mount the electronic components 15 on a dummy circuit board, and the number of incidents of positional deviation of the electronic component was counted. In Table 6, the result is indicated with "A" when no positional deviation occurred, "B" when positional deviation occurred in one to three pieces, and "C" when positional deviation occurred in four or more pieces since this is comparable to or worse than the prior art. The results are shown in Table 6.

Table 6

| Specimen No. | Shape of grooves | | | Positional deviation |
|---|---|---|---|---|
| | Width H of grooves (mm) | Depth I of grooves (mm) | Ratio of depth H to depth I, H/I | |
| 109 | 0.05 | 0.1 | 0.5 | B |
| 110 | 0.08 | 0.1 | 0.8 | B |
| 111 | 0.1 | 0.1 | 1 | A |
| 112 | 0.1 | 0.08 | 1.25 | A |
| 113 | 0.1 | 0.05 | 2 | A |
| 114 | 0.1 | 0.04 | 2.5 | B |
| 115 | 0.1 | 0.03 | 3.33 | B |

The results shown in Table 6 show that positional deviation of the electronic component 15 occurred in three pieces or less among ten million pieces with specimens Nos. 109 to 115 made as Example of the vacuum suction nozzle of the present invention. Since specimens Nos. 109 to 115 had six grooves 8 having a width H in a range from 0.05 to 0.1 mm and a depth I in a range from 0.03 to 0.1 mm, the object (electronic component 15) could be held without positional deviation.

Particularly in specimens Nos. 111 to 113, no positional deviation of the object occurred and therefore it is supposed that width H and depth I of the groove 8 were well balanced and the air flow was not likely to be disturbed near the circumference of the suction surface.

In specimens Nos. 109 and 110, it is supposed that, since width H of the groove 8 was as small as less than 0.1 mm, the air flow FC along the groove 8 was weak and insufficient effect of preventing positional deviation was provided, thus resulting in one to three incidents of positional deviation. In specimens Nos. 114 and 115, it is supposed that, since the depth I of the groove 8 was less than 0.05 mm, the air flow FC along the groove 8 decreased and insufficient effect of preventing positional deviation was provided, thus resulting in one to three incidents of positional deviation.

Therefore, it is supposed that in the case of the second vacuum suction nozzle 1 used in Example 6, sizes of the groove 8 are preferably 0.1 mm or more in width H and 0.05 mm or more in depth I.

(Example 7)

The vacuum suction nozzle 1 was made in the same manner as in Example 6, and four grooves 8 of the shape shown in Fig. 6 were formed so that six grooves 8 divide the circumference of the suction surface 2 into four equal portions. The With H and the depth I of the groove 8 were set as shown in Table 7. The cylindrical portion 5 of the vacuum suction nozzle 1 was formed in sizes of 6 mm in length and 0.85 mm in wall thickness and measuring 2 mm in outer diameter and 0.3 mm in inner diameter, with the groove 8 having a length J of 1 mm. These specimens are referred to as Nos. 116 to 123.

Width H and depth I of the groove 8 were measured by using an ordinary tool microscope.

Then these specimens of the second vacuum suction nozzle 1 were installed on the electronic component mounter 14, and subjected to vacuum suction test of the electronic component 15 of type 0603 (measuring 0.6 mm by 0.3 mm) to check positional deviation of the electronic component 15.

Positional deviation of the electronic component 15 was checked by operating the electronic component mounter 14 to suction ten million pieces and mount the electronic components 15 on a dummy circuit board, and the number of incidents of positional deviation of the electronic component 15 was counted. In Table 7, the result is indicated with "A" when no positional deviation occurred, "B" when positional deviation occurred in one to three pieces, and "C" when positional deviation occurred in four or more pieces since this is comparable to or worse than the prior art.

The results are shown in Table 7.
Table 7

| Specimen No. | Shape of grooves | | | Positional deviation |
|---|---|---|---|---|
| | Width H of grooves (mm) | Depth I of grooves (mm) | Ratio of depth H to depth I, H/I | |
| 116 | 0.1 | 0.1 | 1 | A |
| 117 | 0.2 | 0.1 | 2 | A |
| 118 | 0.22 | 0.1 | 2.2 | B |
| 119 | 0.3 | 0.1 | 3 | B |
| 120 | 0.4 | 0.4 | 1 | A |
| 121 | 0.5 | 0.4 | 1.25 | A |
| 122 | 0.6 | 0.4 | 1.5 | A |
| 123 | 0.7 | 0.4 | 1.75 | B |

The results shown in Table 7 show that positional deviation of the electronic component 15 occurred in three pieces or less among ten million pieces with specimens Nos. 116 to 123 made as Example of the vacuum suction nozzle of the present invention.

Since specimens Nos. 116 to 123, Example of the present invention, had four grooves 8 of width H in a range from 0.1 to 0.7 mm and depth I in a range from 0.1 to 0.4 mm, the object (electronic component 15) could be held without positional deviation. Particularly in specimens Nos. 116 to 117 and 120 to 122 as Examples of the present invention, no positional deviation of the object occurred and therefore it is supposed that width H and depth I of the groove 8 were well balanced and the air flow was not likely to be disturbed near the circumference of the suction surface 2.

In specimens Nos. 118 and 119, it is supposed that, since the depth I of the groove 8 was small relative to the width H, the air flow FC along the groove 8 was small and insufficient effect of preventing positional deviation was provided, thus resulting in one to three incidents of positional deviation. In specimen No. 123, it is supposed that, since the width H of the groove 8 was more than 0.6 mm, forming the grooves 8 had the same effect as that of providing steps which caused such a problem that the air flow FC was disturbed making the object likely to be displaced, thus resulting in one to three incidents of positional deviation.

These results suggest that sizes of the groove 8 of the vacuum suction nozzle 1 are preferably 0.1 mm or more in width H and 0.05 mm or more in depth I as shown by Example 6, while width H is preferably 0.6 mm or less as shown by Example 7. Results of Example 6 and Example 7 show that the air flow FC in the groove 8 becomes unstable when the ratio H/I of the width H to the depth I of the groove 8 exceeds 2. Lower limit of the ratio H/I may be determined in accordance to the wall thickness of the cylindrical portion 5, so as not to damage the cylindrical portion 5.

(Example 8)

Vacuum suction nozzle 1 was made with five grooves 8 formed thereon, missing one groove 8 of the six grooves 8 formed on the specimen No. 111 of the vacuum suction nozzle 1 used in Example 6, as shown in Fig. 11. This vacuum suction nozzle 1 was installed on the electronic component mounter 14, and subjected to suction test of mounting the electronic component 15 of type 0603 (measuring 0.6 mm by 0.3 mm) onto a dummy circuit board to check positional deviation of the electronic component 15.

As a result, positional deviation of the electronic component occurred in three pieces among ten million pieces. Number of incidents of positional deviation of the electronic component 15 was larger than in the case of specimen No. 111 supposedly because the five grooves 8 formed thereon included groove 8a that lacked the mating groove 8 disposed at a position opposite with respect to the center of the suction surface 2 to cause similar air flow FC, thus resulting in partial loss of symmetry of the air flow FC near the circumference of the suction surface 2 that caused the object to incline when suctioned.

As described above, in the vacuum suction nozzle 1 of the present invention, since the air flow from the side face of the vacuum suction nozzle 1 toward the suction orifice 3 is not disturbed, the object can be suctioned precisely onto the predetermined position in the suction surface 2 and, when the object is released from the suction surface 2 at the destination, the object does not stick to the suction surface 2 and can be released in a short period of time when suction of air through the suction orifice 3 is stopped to release the object.

(Example 9)

Vacuum suction nozzle having the continuous surface 7 that changed smoothly from the side face of the cylindrical portion 5 near the suction surface 2 of the vacuum suction nozzle 1 toward the suction surface 2 as in the example shown in Fig. 4, and vacuum suction nozzle having a plurality of grooves formed to run from the side face of the vacuum suction nozzle toward the suction surface as shown in Fig. 6 were made by using the same material and manufacturing as those of specimen No. 7 of Example 1, and were tested for positional deviation and carry-back similarly to Example 1. As a result, both positional deviation and carry-back occurred in three pieces or less with the vacuum suction nozzle having the configurations shown in Fig. 4 and Fig. 6.

As described above, the vacuum suction nozzle 1 of the present invention is capable of reliably holding the electronic component 15 without any positional deviation due to slipping or the like, and therefore the electronic component 15 can be carried without dropping and mounted at the desired mounting position. Also because there is the air flow passage between the crystal grains 22 of the second component and the recesses 15a in the state that the electronic component 15 is suctioned thereon, the electronic component 15 does not stick to the suction surface 2, and the electronic component 15 can be released without taking any time when suction of air through the suction orifice 3 is stopped after mounting. Moreover, the air flow is hardly disturbed significantly by the Venturi effect, and the posture of the object remains stable throughout the period from the time it is picked up from the tray to the time it is suctioned onto the suction surface 2, so that the object can be suctioned at the predetermined position of the suction surface 2, and positional deviation of the electronic component 15 can be suppressed from occurring when it is mounted.

**Claims**

1. A vacuum suction nozzle, comprising:

   a suction surface configured to vacuum suction an object thereon; and
   a suction orifice configured to communicate with the suction surface, wherein
   a tip end portion including the suction surface is formed from ceramics,
   the ceramics contains a main component and a second component, the second component having a mean crystal grain size which is larger than a mean crystal grain size of the main component, and
   crystal grains of the second component protrude more than crystal grains of the main component on the suction surface.

2. The vacuum suction nozzle according to Claim 1, wherein the main component contains zirconia.

3. The vacuum suction nozzle according to Claim 1 or 2, wherein the second component contains alumina.

4. The vacuum suction nozzle according to Claim 1 or 2, wherein the second component contains any one selected from a group consisting of zinc oxide, iron oxide, titanium carbide and titanium nitride.

5. The vacuum suction nozzle according to Claim 4, wherein a value of an electrical resistance of the vacuum suction nozzle over an entire length thereof is not less than $10^3$ Ω nor more than $10^{11}$ Ω.

6. The vacuum suction nozzle according to Claim 1, wherein a portion around the suction orifice of the suction surface protrudes, and the suction surface is curved from a circumferential surface thereof to a side face of the tip end portion.

7. The vacuum suction nozzle according to Claim 1, wherein a plurality of grooves configured to extend to the suction surface are formed on a circumferential surface of the tip end portion of the vacuum suction nozzle.

8. The vacuum suction nozzle according to Claim 7, wherein the plurality of grooves have the same shape each other and are disposed at equal intervals along the circumference of the tip end portion of the vacuum suction nozzle.

*Fig. 1*

(a)

(b)

Fig. 2

*Fig. 3*

*Fig. 4*

*Fig. 5*

Fig. 6

Fig. 7

Fig. 8

*Fig. 9*

(a)

42

40

31

34

35

32

(b)

42　41

40

31

36

34

33

35

32

*Fig. 10*

*Fig. 11*

EP 2 242 348 A1

## INTERNATIONAL SEARCH REPORT

International application No.

PCT/JP2009/050667

| A. CLASSIFICATION OF SUBJECT MATTER |
| --- |
| *H05K13/04(2006.01)i, B25J15/06(2006.01)i* |
| According to International Patent Classification (IPC) or to both national classification and IPC |

| B. FIELDS SEARCHED |
| --- |
| Minimum documentation searched (classification system followed by classification symbols) H05K13/04, B25J15/06 |
| Documentation searched other than minimum documentation to the extent that such documents are included in the fields searched Jitsuyo Shinan Koho 1922-1996 Jitsuyo Shinan Toroku Koho 1996-2009 Kokai Jitsuyo Shinan Koho 1971-2009 Toroku Jitsuyo Shinan Koho 1994-2009 |
| Electronic data base consulted during the international search (name of data base and, where practicable, search terms used) |

| C. DOCUMENTS CONSIDERED TO BE RELEVANT | | |
| --- | --- | --- |
| Category* | Citation of document, with indication, where appropriate, of the relevant passages | Relevant to claim No. |
| Y | JP 10-117099 A (Kyocera Corp.), 06 May, 1998 (06.05.98), Par. Nos. [0018] to [0024]; Figs. 1, 2 (Family: none) | 1-8 |
| Y | JP 2-229758 A (Toray Industries, Inc.), 12 September, 1990 (12.09.90), Full text (Family: none) | 1-8 |
| Y | JP 2003-12368 A (Kyocera Corp.), 15 January, 2003 (15.01.03), Claim 1; Par. Nos. [0033] to [0035], [0049] (Family: none) | 4-5 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search 10 February, 2009 (10.02.09) | Date of mailing of the international search report 24 February, 2009 (24.02.09) |
| --- | --- |
| Name and mailing address of the ISA/ Japanese Patent Office | Authorized officer |
| Facsimile No. | Telephone No. |

Form PCT/ISA/210 (second sheet) (April 2007)

**INTERNATIONAL SEARCH REPORT**

| International application No. |
|---|
| PCT/JP2009/050667 |

C (Continuation).　DOCUMENTS CONSIDERED TO BE RELEVANT

| Category* | Citation of document, with indication, where appropriate, of the relevant passages | Relevant to claim No. |
|---|---|---|
| Y | JP 7-186080 A  (SMC Corp.),<br>25 July, 1995 (25.07.95),<br>Par. No. [0019]; Figs. 1 to 9<br>& US 5582450 A1 　　　　 & US 5707093 A1<br>& US 5904387 A1 　　　　 & GB 2281281 A<br>& GB 2308583 A 　　　　　& DE 4430381 A1 | 6 |
| Y | JP 2003-218590 A  (NEC Corp.),<br>31 July, 2003 (31.07.03),<br>Claim 5; Par. No. [0036]; Fig. 9<br>(Family: none) | 7-8 |
| A | JP 9-87029 A  (Toshiba Corp.),<br>31 March, 1997 (31.03.97),<br>Par. Nos. [0027] to [0029]; Fig. 3<br>(Family: none) | 1-8 |
| A | WO 2005/061188 A1  (Matsushita Electric<br>Industrial Co., Ltd.),<br>07 July, 2005 (07.07.05),<br>Par. No. [0068]<br>(Family: none) | 5 |

Form PCT/ISA/210 (continuation of second sheet) (April 2007)

## REFERENCES CITED IN THE DESCRIPTION

**Patent documents cited in the description**

- JP 2090700 A
- JP 11026933 A
- JP 11099426 A
- JP 4365579 A